# EUROPEAN PATENT APPLICATION

(11) **EP 4 788 072 A1**
(43) Date of publication of application: **05.08.2026**
(21) Application number: 23954201.2
(22) Date of filing: 26.09.2023
(51) Int. Cl.: H05K 7/20

(54) **COOLING SYSTEM AND COOLING METHOD FOR ELECTRONIC APPARATUS**

(71) Applicant: Zyrq Inc., Nagaoka-shi, Niigata 940-0061 (JP)
(72) Inventor: SAITO, Motoaki, Tokyo 106-0043 (JP); SAITO, Kimiaki, Tokyo 101-0062 (JP)
(74) Representative: Goddar, Heinz J.
(86) International application number: PCT/JP2023/035025
(87) International publication number: WO 2025/069225

(57) **Abstract**

To provide a simple and efficient cooling system and cooling method with which the cooling performance of an electronic apparatus is improved.

This cooling system includes a cooling intermediate composite body. The intermediate composite body includes a non-conductive bag for wrapping a piece of the electronic apparatus that includes a substrate and a heat-generating element mounted on the substrate, and a heat sink device. The heat sink device includes a thermal conductive base block placed inside a bag and a thermal conductive outer block placed outside the bag and fixed to the base block. A first opening is formed on the bag 11. When the outer block 21A is fixed to the base block 21B, both are thermally connected through the first opening of the bag 11. The back surface of the outer block 21A and the surface of the base block 21B maintain watertightness on both sides of a region around the opening of the bag 11. The back surface of the base block 21B provides a connecting surface that is thermally connected to one side of a heat-generating element 33.

## Description

### BACKGROUND

The present invention relates to a cooling system and a cooling method for electronic apparatuses and more particularly to the cooling system and the cooling method of efficiently cooling the electronic apparatuses, such as a supercomputer, that is used for a data center, an artificial intelligence processing system, a quantum computing system, a cryptographic processing system, or a blockchain processing system, for example, and requires high performance, stable operation, or low power consumption operation and generates a large amount of heat.

One of the biggest challenges determining the performance limits of computer-related equipment in recent years is power consumption. The importance of research into thrifty power consumption, particularly in supercomputers, is already widely recognized. Speed performance per watt (Flops/W) is one index for evaluating supercomputers. Cooling is estimated to consume more than 30% of the total power consumed by a data center, generating a growing demand for power reduction through improved cooling efficiency.

Conventional cooling methods become incapable of cooling the data centers in the summer due to recent global warming and extreme heat caused by weather anomalies. There is an urgent need to improve the cooling capacity of existing systems.

The processing power of data centers and computer systems must be increased exponentially in terms of the rapid growth of artificial intelligence processing, the increasing need for encryption processing, the rapid increase in cryptocurrency mining as a key example of blockchain processing, and the development of the metaverse, which is broadly predicted to grow rapidly. There is a remarkably increasing demand for enhanced cooling capacity.

Conventionally, air-cooled and liquid-cooled types are used to cool supercomputers and data centers. The liquid-cooled type is generally considered to exhibit better cooling efficiency because it uses liquid whose heat transference is significantly better than air. For example, the "TSUBAME-KFC" supercomputer, developed by the Tokyo Institute of Technology, achieved 4.50 G Flops/W using a synthetic oil immersion cooling system. It ranked first in the "Green500 List" of supercomputers published in November 2013 and June 2014. However, the coolant uses synthetic oil, which is highly viscous and forms an oil film. It is difficult to completely remove the oil from an electronic apparatus taken out of an oil-immersion rack, making the electronic apparatus maintenance (specifically such as adjustment, inspection, repair, replacement, and expansion) extremely difficult. Furthermore, operational troubles are reported due to the synthetic oil used, which corrodes and damages a packing material, for example, included in electronic printed circuit boards or the cooling system in a short time or leaks the refrigerant.

As a solution, an immersion cooling system is proposed that utilizes a fluorocarbon-based coolant instead of synthetic oil or mineral oil, which causes the aforementioned problems. Specific examples include the use of fluorocarbon-based coolants such as hydrofluoroether (HFE) compounds known as 3M's "Novec 7100," "Novec 7200," and "Novec 7300" (Novec is a trademark of 3M) (for example, Japanese Unexamined Patent Application Publication No. 2013-187251, and Japanese Translation of PCT International Application Publication No. JP-T-2012-527109).

Since 2014, one of the inventors has been developing a new immersion cooling system and related technologies to directly cool electronic apparatuses by circulating a hardly evaporable coolant, containing a perfluorinated compound as its primary component, inside the open space of a cooling tank (For example, Japanese Patent No. 5853072).

However, PFAS (perfluoroalkyl substances and polyfluoroalkyl substances), including all of these fluorocarbon-based coolants, have long been known to have adverse effects on humans, crops, and the natural environment. In December 2022, the world's largest manufacturer announced that it would completely cease production by the end of 2025. In Europe, both the production and use of PFAS are expected to be banned by law within the next few years.

There is a need for a new immersion cooling method that is more affordable and can be used widely worldwide without the use of any harmful compounds such as PFAS as a refrigerant, and excels more highly in the cooling capacity compared to immersion cooling methods using PFAS as a refrigerant, for example.

There is a typical example of a cooling method that does not use harmful compounds such as PFAS as a refrigerant and can use ordinary water (tap water or industrial water) rather than pure water. Specifically, the method attaches a "water-cooled block," containing a running water path for water to flow, to the inside of a copper or aluminum block instead of using a heat sink that is attached directly to the top surface of the semiconductor of the CPU (central processing unit) as the main heat source in a computer apparatus. (For example, Japanese Unexamined Patent Application Publication No. 2016-119345).

Another cooling method that can utilize water is proposed. A semiconductor chip mounted on a printed circuit board is placed in a flexible bag. The bag is then immersed in a container filled with water as a coolant. The bag is then closely attached to the semiconductor device by shrinking and deforming the bag due to a pressure difference between the inside and outside of the bag when the bag is filled with water or the pressure inside the bag is reduced (For example, Japanese Patent No. 2804640).

Still another cooling method using water is proposed: a natural water-cooled computer, which uses river, lake, seawater, or tap water as a cooling source to directly cool the computer. Specifically, this cooling method immerses a computer in water by coating the printed circuit board surface with parylene resin (For example, Ikki Fujiwara, et al. "The First Step Towards Direct Natural Water-Cooled Computers." Information Processing Society of Japan, Technical Report, High Performance Computing (HPC), 2017-HPC-158(5), March 1, 2017. pp. 1-5. URL:http://research.nii.ac.jp/~koibuchi/pdf/ikki-sighpc158.pdf).

Yet another cooling method is proposed to completely coat the entire printed circuit board with an ultra-nanohydrophobic thin film coating using silicon compound nanoparticles, make the electronic apparatus excellent in waterproof and moisture-resistant properties, and immerse it in water (For example, U.S. Patent No. 10717881).

### SUMMARY

The cooling system disclosed in Japanese Unexamined Patent Application Publication No. 2016-119345 uses water as a refrigerant, instead of using hazardous substances such as PFAS as a refrigerant, as described in Japanese Unexamined Patent Application Publication No. 2013-187251, Japanese Translation of PCT International Application Publication No. JP-T-2012-527109, and Patent No. 5853072. A running water path is provided in the water-cooled block attached to the surface of the semiconductor element mounted in the electronic apparatus. The cooling system first cools the water-cooled block, and then only the semiconductor element directly being in contact with the water-cooled block. No cooling is applied to other electronic components and printed circuit boards that do not directly come into contact with the water-cooled block, generate unignorable, if not significant, heat, and still require cooling. Additional cooling, such as air cooling, is required. Modern supercomputers or electronic apparatuses used in data centers require cooling for not only the central processing unit (CPU), but also many other components such as graphics processing units (GPUs), high-speed memory, chipsets, power-related components such as field-effect transistors (FETs), electrolytic capacitors, network units, bus switch units, and solid-state drives (SSDs). These components generate significantly different amounts of heat. It is difficult to satisfactorily cool them all by using air cooling, which is inferior to liquid cooling in terms of cooling capacity. The water-cooled block generally requires a large supply of cooling water. The water-cooled block itself is large and is not shaped into fins like a heat sink, obstructing the airflow path for air cooling. At least two piping paths are required to supply water to and return water from the water-cooled block. The piping paths to cool the water-cooled block also obstruct the airflow path for air cooling to no small extent, resulting in extremely low cooling efficiency for objects not directly cooled by the water-cooled block. In terms of objects directly cooled by the water-cooled block, the flow paths in the water-cooled block are often limited to a tube structure whose cross-section is about 3 mm or 5 mm in diameter. There is a significant restriction on the flow rate through the flow paths, compared to the flow rate at which a typical heat sink with many fins directly contacts the refrigerant water. It is easy to predict that the cooling performance will be significantly insufficient for the latest CPUs, whose consumed power greatly exceeds 100 W, or high-performance GPUs for generative AI, whose consumed power exceeds 500 W.

The cooling system disclosed in Ikki Fujiwara, et al. "The First Step Towards Direct Natural Water-Cooled Computers." Information Processing Society of Japan, Technical Report, High Performance Computing (HPC), 2017-HPC-158(5), March 1, 2017. pp. 1-5. URL:http://research.nii.ac.jp/~koibuchi/pdf/ikki-sighpc158.pdf, completely coats the whole of electronic components and printed circuit boards with an electrically non-conductive, water-impermeable parylene thin film coating. The electronic components and printed circuit boards coated with the parylene thin film coating are then entirely immersed in water or seawater. The apparatus is cooled using the low temperature of the water or seawater that comes into contact with the entire parylene thin film coating.

Similarly, the cooling system disclosed in U.S. Patent No. 10717881 completely coats the whole of electronic components and printed circuit boards with an ultra-nanohydrophobic thin film coating using electrically non-conductive, water-impermeable silicon compound nanoparticles. The electronic components and printed circuit boards coated with the ultra-nanohydrophobic thin film coating are then entirely immersed in water. The apparatus is cooled using the low temperature of the water that comes into contact with the entire hydrophobic thin film coating.

In both the cooling systems described in Japanese Unexamined Patent Application Publication No. 2013-187251 and U.S. Patent No. 10717881, the electronic components and printed circuit boards to be cooled are all in contact with water or seawater as a coolant, via the parylene thin film or hydrophobic thin film coating. When a CPU, as a major heat source, needs to be cooled efficiently, cooling capacity and efficiency are inevitably inferior to a cooling system that uses a coolant such as water to directly cool the heat sink by directly contacting the surface of a semiconductor, such as a water-cooled block, for example.

According to the above-described thin-film coating method, even a slight leakage from the coating can cause water to enter the coated electronic components and printed circuit boards. When power is applied, all the electronic components and printed circuit boards are short-circuited and irreversibly damaged. Complete coating is essential. However, other than visual inspection, the only way to determine an occurrence of short-circuiting is to apply power to the electronic apparatus. There is always a risk of losing objects when they are cooled. The problem of coating leakage is not limited to the time when the electronic apparatus is first used. Also, after the electronic apparatus is used, thin film coating may be subsequently damaged due to deterioration or aging, or even slight contact with other electronic apparatuses, inspection apparatuses, or tools during maintenance and inspection. There poses a dilemma. The parylene or hydrophobic thin film coating needs to be as thin as possible to increase thermal conductivity from the refrigerant for cooling. Contrastingly, the thin film coating must be thick enough to prevent leakage and breakdown, and damage to the electronic apparatus.

Recent electronic printed circuit boards and their shapes are increasingly complex three-dimensionally and continue to become reduced in size. Considerable technical challenges are expected to establish a technology that completely coats these components with a defect-free, perfect thin film. Cooling systems using these thin film coatings remain almost unpopular.

These thin films need to be coated strongly through the use of vapor deposition, for example. Electronic components or printed circuit boards whose surfaces are reformed are no longer covered by the quality assurance. Their use is at your own risk. It is very difficult to find a need to convert the coated and completely used electronic components to different purposes or resell them. In principle, their reuse or resale cannot be expected.

The water-cooling method disclosed in Japanese Patent No. 2804640 cools a semiconductor device by placing it in a flexible bag and immersing it in a coolant such as water. However, like thin-film coatings, bags prevent direct contact between the semiconductor device surface and the coolant, thereby limiting cooling performance.

As above, immersion cooling using PFAS, as a conventional liquid cooling method, will become unusable shortly. Without the use of PFAS, the use of non-conductive liquids, such as synthetic oils and silicones, results in insufficient cooling capacity. The immersion cooling system using water, having high cooling capacity, requires ensuring non-conductivity by thoroughly coating with a thin film to prevent leakage. However, a perfect coating is becoming increasingly difficult and remains unpopular with the progress of 3D printed circuit board structures and the miniaturization of electronic components.

The conventional liquid cooling method using a water-cooled block can achieve a certain level of cooling performance for the CPU as the main heat source. However, the large water-cooled block and the piping path for water cooling prevent sufficient cooling for the many other electronic components and printed circuit boards that are cooled by air cooling. The cooling performance of water-cooled blocks is no longer sufficient for the most recent CPUs and GPUs, which indicate high heat values.

There is also a problem with the conventional liquid cooling method of placing a semiconductor device in a flexible bag and immersing it in water for cooling. The bag prevents direct contact between the semiconductor device surface and the refrigerant, thereby limiting cooling performance.

Accordingly, an object of the present invention is to provide a simple, efficient, and inexpensive cooling system and method that solves the above-described problems of the prior art, improves the cooling performance of electronic apparatuses, and excels in maintainability.

To solve the above problems, one aspect of the present invention provides a cooling system in which the electronic apparatus is immersed in ordinary water (such as tap water, industrial water, or seawater), representing a typical example of electrically conductive and highly thermally conductive coolant, and the water directly cools a heat sink device, which is often made of copper or aluminum and is thermally connected to electronic components including a CPU, as the main heat source. The cooling system according to a preferred embodiment of the invention includes a cooling intermediate composite body. The cooling intermediate composite body includes a non-conductive bag for encasing the electronic apparatus that includes a printed circuit board and at least one heat-generating element mounted on the printed circuit board and the heat sink device. The heat sink device includes a thermal conductive base block placed inside the non-conductive bag and a thermal conductive outer block placed outside the non-conductive bag and fixed to the base block. A second opening is formed in the non-conductive bag. When the outer block is fixed to the base block, the outer block and the base block are thermally connected through the first opening of the non-conductive bag. The back surface of the outer block and the surface of the base block maintain watertightness on both sides of the region around the first opening in the non-conductive bag. The back surface of the base block provides a connecting surface thermally connected to one side of at least one heat-generating element.

In a preferred embodiment of the cooling system, an elevated portion may be formed on the back surface of the outer block or the surface of the base block. The elevated portion may contact the surface of the base block or the back surface of the outer block through the first opening of the non-conductive bag.

In a preferred embodiment of the cooling system, the first opening formed in the non-conductive bag may be larger than the elevated portion.

Further, in a preferred embodiment of the cooling system, a thermal conductive sheet or thermal conductive grease may be placed to fill the first opening of the non-conductive bag. The back surface of the outer block may contact the surface of the base block via the thermal conductive sheet or the thermal conductive grease.

Then, in a preferred embodiment of the cooling system, the outer block may include a thermal conductive lower outer block and a thermal conductive upper outer block that is thermally connected and fixed to the surface of the lower outer block. When the lower outer block is fixed to the base block, the back surface of the lower outer block and the surface of the base block may maintain watertightness on both sides of the region around the first opening in the non-conductive bag.

Additionally, in a preferred embodiment of the cooling system, the base block may include a thermal conductive lower base block and a thermal conductive upper base block that is thermally connected and fixed to the surface of the lower base block. When the outer base block is fixed to the upper base block, the back surface of the outer base block and the surface of the upper base block may maintain watertightness on both sides of the region around the first opening in the non-conductive bag.

In a preferred embodiment of the cooling system, the outer block may include the thermal conductive lower outer block and the thermal conductive upper outer block that is thermally connected and fixed to the surface of the lower outer block. On the other hand, the base block may include the thermal conductive lower base block and the thermal conductive upper base block that is thermally connected and fixed to the surface of the lower base block. When the lower outer block is fixed to the upper base block, the back surface of the lower outer block and the surface of the upper base block may maintain watertightness on both sides of the region around the first opening in the non-conductive bag.

Additionally, in a preferred embodiment of the cooling system, a plurality of convex surfaces of different heights may be formed on the back surface of the base block or the back surface of the lower base block. The plurality of the convex surfaces may be thermally connected to the plurality of the surfaces of a plurality of heat-generating elements of different heights.

In a preferred embodiment of the cooling system, the base block or the lower base block may include a PCB fixing mechanism. The printed circuit board of the electronic apparatus may be fixed to the PCB fixing mechanism of the base block or the lower base block.

Further, in a preferred embodiment of the cooling system, the PCB fixing mechanism of the base block or the lower base block may provide two or more threaded holes that are formed apart from each other on the back surface of the base block or the lower base block.

In a preferred embodiment of the cooling system, the cooling intermediate composite body may further include a bonding layer that makes a watertight connection between the back surface of the outer block and the exterior of the non-conductive bag, or between the surface of the base block and the interior of the non-conductive bag. The bonding layer may be formed of a heterogeneous-material bonding film, double-sided adhesive tape, or watertight packing. A second opening, corresponding to the first opening in the non-conductive bag, may be formed on the heterogeneous-material bonding film, for example. The outer block and base block may be thermally connected through the first opening in the non-conductive bag and the second opening in the bonding layer.

In a preferred embodiment of the cooling system, an elevated portion may be formed on the back surface of the outer block or the surface of the base block. The elevated portion may contact the surface of the base block or the back surface of the outer block through the first opening of the non-conductive bag and the second opening in the bonding layer.

In a preferred embodiment of the cooling system, the first opening in the non-conductive bag and the second opening in the bonding layer may favorably have an opening area that is greater than the area of the elevated portion.

Further, in a preferred embodiment of the cooling system, the thermal conductive sheet or the thermal conductive grease may be placed to fill the first opening of the non-conductive bag and the second opening of the bonding layer. The back surface of the outer block may contact the surface of the base block via the thermal conductive sheet or the thermal conductive grease.

In a preferred embodiment of the cooling system, the outer block may include the thermal conductive lower outer block and the thermal conductive upper outer block that is thermally connected and fixed to the surface of the lower outer block. When the lower outer block is fixed to the base block, the back surface of the lower outer block and the surface of the base block may maintain watertightness of the region around the first opening of the non-conductive bag and the region around the second opening of the bonding layer.

Further, in a preferred embodiment of the cooling system, the base block may include the thermal conductive lower base block and the thermal conductive upper base block that is thermally connected and fixed to the surface of the lower base block. When the outer block is fixed to the upper base block, the back surface of the outer block and the surface of the upper base block may maintain watertightness of the region around the first opening of the non-conductive bag and the region around the second opening of the bonding layer.

In a preferred embodiment of the cooling system, the outer block may include the thermal conductive lower outer block and the thermal conductive upper outer block that is thermally connected and fixed to the surface of the lower outer block. On the other hand, the base block may include the thermal conductive lower base block and the thermal conductive upper base block that is thermally connected and fixed to the surface of the lower base block. When the lower outer block is fixed to the upper base block, the back surface of the lower outer block and the surface of the upper base block may maintain watertightness of the region around the first opening of the non-conductive bag and the region around the second opening of the bonding layer. The material used for the outer block, upper outer block, or lower outer block may differ from the material used for the base block, upper base block, or lower base block.

Further, in a preferred embodiment of the cooling system, the heat sink device may include a plurality of radiating fins placed outside the non-conductive bag.

Furthermore, in a preferred embodiment of the cooling system, the cooling intermediate composite body may be configured so that the interior of the non-conductive bag closely contacts both sides of the printed circuit board and the surfaces of various electronic components mounted on the printed circuit board when the non-conductive bag is vacuumized inside.

In a preferred embodiment of the cooling system, the non-conductive bag may be configured to include a check valve that can provide a path for vacuumization and maintain hermeticity.

When the non-conductive bag is immersed in coolant, the interior of the non-conductive bag may be configured to passively adhere to the surface of a printed circuit board, for example, due to the fluid pressure of the surrounding coolant, instead of vacuumization. In this case, the non-conductive bag may include an opening or valve for expelling air existing between the non-conductive bag and the printed circuit board, or may be structured to be partially opened above the liquid level.

In a preferred embodiment of the cooling system, the non-conductive bag may include a zipper mechanism. The zipper mechanism may be configured so that an opened-zipper state permits placement of the electronic apparatus in the non-conductive bag, while a closed-zipper state maintains hermeticity of the non-conductive bag.

In a preferred embodiment of the cooling system, the non-conductive bag may include a heat-sealing mechanism. The heat-sealing mechanism may be configured so that an unheat-sealed state permits placement of the electronic apparatus in the non-conductive bag and vacuumization after heat sealing, while a heat-sealed state maintains hermeticity of the non-conductive bag.

In a preferred embodiment of the cooling system, the non-conductive bag may form a penetration portion for passing a power cable, a network communication cable, or a control cable connected to an electronic apparatus. The sealing material provided for the penetration portion may be configured to maintain hermeticity of the non-conductive bag.

In a preferred embodiment of the cooling system, the cooling intermediate composite body may further include, in the non-conductive bag, a wireless power supply unit for supplying power to the electronic apparatus and a wireless communication unit for enabling wireless communication between the electronic apparatus and the outside.

In a preferred embodiment of the cooling system, the cooling system may further include, in the non-conductive bag, a monitor unit for monitoring the degree of vacuum or the conductivity in the non-conductive bag.

The cooling system according to a preferred embodiment may further include a controller that provides control to activate an external vacuum pump and vacuumize the non-conductive bag inside when output from the monitor unit indicates a vacuum level below a predetermined threshold.

In a preferred embodiment of the cooling system, the cooling system, according to a preferred embodiment, may further include a shutdown unit that stops operation of the electronic apparatus and turns off power when output from the monitor unit indicates a vacuum level below a predetermined threshold or the conductivity greater than or equal to a predetermined threshold.

In addition, another aspect of the present invention provides a cooling method for the electronic apparatuses, including the steps of: preparing the heat sink device that includes the thermal conductive base block and the thermal conductive outer block; preparing the non-conductive bag that encloses the electronic apparatus including the printed circuit board and at least one heat-generating element mounted on the printed circuit board and includes a first opening formed for the heat sink device; configuring the cooling intermediate composite body including a step of fixing the outer block, placed outside the non-conductive bag, to the thermal conductive base block placed inside the non-conductive bag, characterized by that, when the outer block is fixed to the base block, the outer block is thermally connected to the base block through the opening formed on the non-conductive bag, and the back surface of the outer block and the surface of the base block maintain watertightness on both sides of a region around the first opening of the non-conductive bag; placing the electronic apparatus in the cooling intermediate composite body and fixing the base block to the printed circuit board so that one surface of at least one heat-generating element makes surface contact with and thermally connects with the back surface of the base block; making the non-conductive bag watertight at least partially; and immersing, in a refrigerant, a watertight part of the at least partially watertight cooling intermediate composite body.

Still another aspect of the present invention provides the cooling method for electronic apparatuses, including the steps of: preparing the heat sink device that includes the thermal conductive base block and the thermal conductive outer block; preparing the non-conductive bag that encloses the electronic apparatus including the printed circuit board and at least one heat-generating element mounted on the printed circuit board and includes an opening formed for attaching the heat sink device; allowing one surface of at least one heat-generating element included in the electronic apparatus to make surface contact with and thermally connects with the back surface of the base block of the heat sink device; configuring the cooling intermediate composite body that places the electronic apparatus in the non-conductive bag and fixes the outer block placed outside the non-conductive bag to the base block, characterized by that, when the outer block is fixed to the base block, the back surface of the outer block contacts the surface of base block through the opening formed on the non-conductive bag, and the back surface of the outer block and the surface of the base block maintain watertightness on both sides of a region around the first opening of the non-conductive bag; making the non-conductive bag watertight at least partially; and immersing, in a refrigerant, a watertight part of the at least partially the watertight cooling intermediate composite body.

According to a preferred embodiment of the above-described cooling method, the step of fixing the outer block to the base block may include a step of using a heterogeneous-material bonding film for bonding between the back surface of the outer block and the exterior of the non-conductive bag, or between the surface of the base block and the interior of the non-conductive bag.

Additionally, according to a preferred embodiment of the above-described cooling method, the step of sealing the non-conductive bag may include a step of vacuumizing the non-conductive bag.

The cooling system according to the present invention uses the cooling intermediate composite body that includes the non-conductive bag, which encloses the electronic apparatus including the printed circuit board and at least one heat-generating element mounted on the printed circuit board, and the heat sink device. The heat sink device includes the thermal conductive base block, which allows its major structural parts to be placed inside the non-conductive bag, and the thermal conductive outer block, which allows its major structural parts to be placed outside the non-conductive bag and is fixed to the base block. The first opening is formed on the non-conductive bag. When the outer block is fixed to the base block, the outer block and the base block are thermally connected through the first opening in the non-conductive bag. The back surface of the outer block and the surface of the base block maintain watertightness on both sides of the region around the first opening in the non-conductive bag. The back surface of the base block provides a connecting surface thermally connected to one side of at least one heat-generating element. When the cooling intermediate composite body is immersed in the coolant, the coolant absorbs heat directly from the surface of the outer block and absorbs heat locally and fully from the heat-generating element thermally connected to the back surface of the base block. When the outer block of the heat sink device is fixed to the base block, the outer block and base block are thermally connected through the first opening in the non-conductive bag. Consequently, the non-conductive bag does not prevent or hinder the heat transfer from the base block to the outer block. When the outer block of the heat sink device is fixed to the base block, the back surface of the outer block and the surface of the base block maintain watertightness on both side of the region around the first opening in the non-conductive bag. It is possible to ensure the watertightness of the cooling intermediate composite body as a whole, even if an opening (window) is formed on the non-conductive bag. Conventional cooling methods of immersion in a conductive coolant, such as water or seawater, face the problem that a coating or bag used to keep the electronic apparatus watertight from the surrounding coolant hinders heat transfer between the heat-generating element and the coolant or the flow of the coolant. Contrastingly, the cooling system according to the present invention utilizes the cooling intermediate composite body configured as above, thereby enabling the complete elimination of heat transfer issues between the heat-generating element and the coolant encountered in conventional methods, and improving the cooling performance of the electronic apparatus. In addition, the cooling intermediate composite body as a whole can provide a strong and stable watertight structure even if an opening (window) is formed on the non-conductive bag.

The heat sink device is divided into an outer block and a base block. Consequently, when the back surface of the base block is thermally connected to one or more heat-generating elements mounted on the printed circuit board, the base block can be first fixed to the printed circuit board, and then the outer block can be fixed to the base block fixed to the printed circuit board. This can mechanically protect the heat-generating elements from an external force applied to fix the outer block to the base block.

This is particularly advantageous when fixing the heat sink device to each heat-generating element on an electronic apparatus, including a printed circuit board relatively highly densely mounted with many (such as 8, 16, or more) heat-generating elements. A standard procedure is to first fix the base block for all heat-generating elements to the printed circuit board. After the base block is fixed, the outer block is fixed to the base block. This two-step fixing method offers significant advantages in terms of work efficiency, yield, and mass production, compared to a method of repeating the procedure to fix one heat sink device to one heat-generating element. After the base block is fixed, the base block mechanically protects the surfaces of all heat-generating elements of the electronic apparatus. While the outer block is fixed, it is possible to avoid the risk of an external force damaging other heat-generating elements, to which the base block is not fixed, than the targeted heat-generating element, or improve work accuracy, thus significantly improving work efficiency, yield, and mass productivity.

The outer block can be configured to include the thermal conductive lower outer block and the thermal conductive upper outer block that is thermally connected to and fixed to the surface of the lower outer block. Then, the upper outer block can have the function of external heat dissipation. The lower outer block and the base block can have the function of maintaining watertightness of the region around the first opening of the non-conductive bag and transferring heat through the opening. The base block can have the function of removing heat from the heat-generating element and protecting the heat-generating element. Similarly, the base block can be configured to include the thermal conductive lower base block and the thermal conductive upper base block that is thermally connected to and fixed to the surface of the lower base block. Then, the outer block can have the function of external heat dissipation, watertightness maintenance, and heat transfer. The outer block and upper base block can have the function of watertightness maintenance and heat transfer. The lower base block can have the function of heat removal and protection. Furthermore, the outer block can be configured to include the lower outer block and the upper outer block, and the base block can be configured to include the lower base block and the upper base block. Then, the upper outer block can have the function of external heat dissipation. The lower outer block and the upper base block can have the function of watertightness maintenance and heat transfer. The lower base block can have the function of heat removal and protection. Consequently, heat removal characteristics can be adjusted by appropriately assigning the heat dissipation, watertightness maintenance, heat transfer, heat removal, and protection functions to the three or four blocks configuring the heat sink device. It is possible to appropriately select and adjust the configuration of the three or four blocks (likely including one or more intermediate blocks placed between the upper and lower blocks), namely, the combination of shapes or materials, and therefore greatly increase the flexibility in the functional design of the heat sink device. It is possible to easily and optimally configure various heat sink devices compatible with the electronic apparatuses that feature various refrigerant heat transfer characteristics and include heat dissipators having various heat generation characteristics. Materials used for the outer block, the upper outer block, or the lower outer block can differ from those for the base block, the upper base block, or the lower base block. Then, for example, it is possible to configure the heat sink device with enhanced heat dissipation performance by using aluminum for the base block (upper base block and lower base block) and copper, characterized by a higher thermal conductivity than aluminum, for the outer block (upper outer block and lower outer block).

The plurality of the convex surfaces of different heights can be formed as needed on the back surface of the base block or the back surface of the lower base block. The plurality of the convex surfaces can be thermally connected to the plurality of the surfaces of the plurality of the heat-generating elements of different heights. Then, it is beneficial to efficiently remove heat from a large heat-generating element that includes a plurality of semiconductor chips. A heterogeneous integration structure, also known as a multi-die package, in which the plurality of the semiconductor chips are mounted two-dimensionally on a single printed circuit board package (sometimes mounted via an interposer), is already put to practical use. Such a heterogeneous integration structure may cause different surface heights of the plurality of the semiconductor chips. The back surface of the base block may be appropriately processed without modifying the outer block. Alternatively, the back surface of the lower base block may be appropriately processed without modifying the upper base block. Then, by assembling the whole, it is possible to ensure thermal connection with the plurality of the heat-generating elements. Only one component (usually a plate-shaped member) of the heat sink device needs to be processed, making it possible to improve work efficiency. It may be advantageous to prepare the outer blocks, the upper base blocks, the upper outer blocks, and the lower outer blocks that can be used in common with other base blocks or the lower base blocks. The combination of these can provide the heat sink devices that are appropriate for mass production. The back surface of the base block or the lower base block may need to be processed into a complex shape. However, work efficiency can be improved by selecting a metal that is easily processable and relatively soft for the base block. When the coolant is water, anticorrosion characteristics are required for materials of the outer blocks (upper outer block and lower outer block) that need to directly contact water. Meanwhile, anticorrosion characteristics are not required for materials of the base blocks (upper base block and lower base block) that are guaranteed to be watertight. It is greatly advantageous to provide the heat sink devices that are appropriate for mass production by flexibly selecting materials for respective blocks.

A bonding layer can be included to make a watertight connection between the back surface of the outer block and the exterior of the non-conductive bag, or between the surface of the base block and the interior of the non-conductive bag. The bonding layer can be made of a heterogeneous-material bonding film, double-sided adhesive tape, or watertight packing. A second opening corresponding to the first opening in the non-conductive bag can be formed on the heterogeneous-material bonding film, for example. Then, a stronger and more stable watertight connection can be made between the back surface of the outer block and the exterior of the non-conductive bag, or between the surface of the base block and the surface of the bag. It is possible to further improve the watertightness function of the outer block and base block and the durability of that function.

The non-conductive bag may be made of a synthetic resin (such as polyethylene, polypropylene, or polyester) that is water-resistant and relatively heat-resistant (for example, 100°C or higher) and can maintain hermeticity (airtightness/watertightness) when sealed. It is possible to provide the cooling intermediate composite body simply, efficiently, and inexpensively. The electronic apparatus can be maintained simply by breaking the non-conductive bag of the cooling intermediate composite body and removing the electronic apparatus from the bag, ensuring excellent maintainability. Furthermore, it is possible to almost completely eliminate the risk of the electronic apparatus surface being contaminated by foreign matter. This is also advantageous from the viewpoint of reusing the used electronic apparatuses.

When an electronic apparatus is cooled, the non-conductive bag in the cooling intermediate composite body can be entirely or at least partially watertight. When the non-conductive bag is entirely watertight, the entire cooling intermediate composite body can be immersed in a coolant to cool the electronic apparatus. When the non-conductive bag is at least partially watertight, the watertight part of the cooling intermediate composite body can be immersed in a coolant to cool the electronic apparatus. For example, the non-conductive bag can be made of flexible synthetic resin. While part of the bag (such as the top thereof) is left open, the cooling intermediate composite body is gradually immersed in the coolant to press the bag due to the surrounding coolant pressure. Consequently, the air in the bag can be discharged outside. Concurrently, the interior of the bag can relatively closely contact both sides of the printed circuit board and the surfaces of various electronic components mounted on the printed circuit board.

The above-described and other objects and advantages of the present invention will be more clearly understood through the following description of the embodiment. However, the embodiment described below provides mere examples, and the present invention is not limited thereto.

### BRIEF DESCRIPTION OF THE DRAWINGS

Fig. 1A is a front view illustrating the configuration of main parts of a cooling system according to an embodiment of the present invention.
Fig. 1B is a side view illustrating the main parts of the cooling system according to an embodiment of the present invention.
Fig. 2A is a diagram illustrating the outer block of a heat sink device applied to an example of a cooling intermediate composite body.
Fig. 2B is a diagram illustrating the outer block of the heat sink device applied to an example of the cooling intermediate composite body.
Fig. 2C is a diagram illustrating the base block of the heat sink device applied to an example of the cooling intermediate composite body.
Fig. 2D is a perspective view of the heat sink device applied to an example of the cooling intermediate composite body.
Fig. 3 is an exploded view illustrating one example of the cooling intermediate composite body.
Fig. 4A is a plan view illustrating an example of the cooling intermediate composite body.
Fig. 4B is a rear view illustrating an example of the cooling intermediate composite body.
Fig. 5 is a cross-sectional view illustrating one example of the cooling intermediate composite body.
Fig. 6 is an explanatory diagram illustrating an example of placing an electronic apparatus in the cooling intermediate composite body.
Fig. 7 is a cross-sectional view illustrating an example of placing the electronic apparatus in the cooling intermediate composite body.
Fig. 8 is a cross-sectional view illustrating an example of placing the electronic apparatus in the cooling intermediate composite body.
Fig. 9 is a cross-sectional view illustrating another example of placing the electronic apparatus in the cooling intermediate composite body.
Fig. 10 is a cross-sectional view illustrating another example of placing the electronic apparatus in the cooling intermediate composite body.
Fig. 11 is an explanatory diagram illustrating an example of configuring the cooling intermediate composite body by mounting the electronic apparatus equipped with a base block.
Fig. 12 is a perspective view illustrating a plurality of heat sink devices mounted on a printed circuit board of the electronic apparatus densely mounted with a plurality of semiconductor devices.
Fig. 13 is a diagram illustrating an operation of the cooling system.
Fig. 14 is a plan view illustrating a heterogeneous-material bonding film.
Fig. 15 is a plan view illustrating a thermal conductive sheet.
Fig. 16 is a schematic cross-sectional view illustrating another example of mounting the electronic apparatus on the cooling intermediate composite body.
Fig. 17 is a schematic cross-sectional view illustrating still another example of mounting the electronic apparatus on the cooling intermediate composite body.
Fig. 18 is a schematic cross-sectional view illustrating still another example of mounting the electronic apparatus on the cooling intermediate composite body.
Fig. 19 is a schematic cross-sectional view illustrating yet other three examples of mounting the electronic apparatus on the cooling intermediate composite body.
Fig. 20 is a schematic cross-sectional view illustrating yet other three examples of mounting the electronic apparatus on the cooling intermediate composite body.
Fig. 21 is a schematic cross-sectional view illustrating yet other three examples of mounting the electronic apparatus on the cooling intermediate composite body.
Fig. 22 is a schematic cross-sectional view illustrating yet other three examples of mounting the electronic apparatus on the cooling intermediate composite body.
Fig. 23 is a schematic cross-sectional view illustrating yet other three examples of mounting the electronic apparatus on the cooling intermediate composite body.
Fig. 24 is a schematic cross-sectional view illustrating yet other two examples of mounting the electronic apparatus on the cooling intermediate composite body.
Fig. 25 is a schematic cross-sectional view illustrating still another example of mounting the electronic apparatus on the cooling intermediate composite body.
Fig. 26 is a schematic cross-sectional view illustrating still another example of mounting the electronic apparatus on the cooling intermediate composite body.
Fig. 27 is a schematic cross-sectional view illustrating still another example of mounting the electronic apparatus on the cooling intermediate composite body.

### DETAILED DESCRIPTION

The following describes in detail preferred embodiments of the cooling method according to the present invention, by referencing the plurality of the drawings.

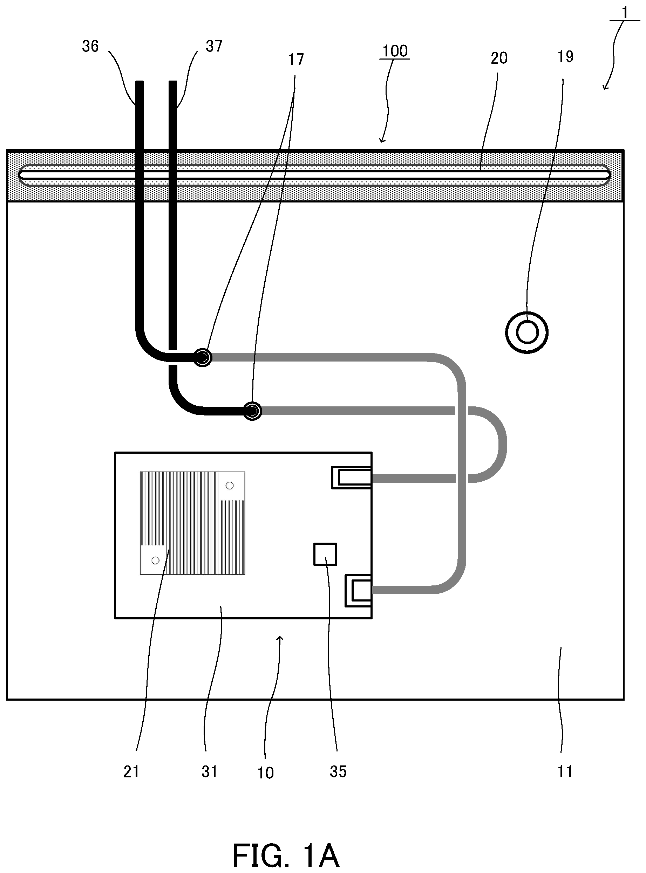

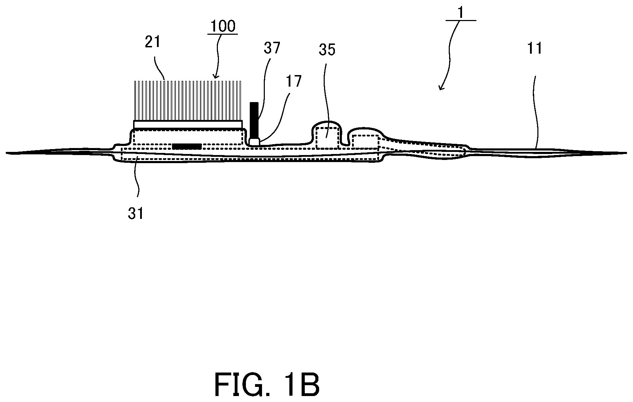

With reference to Fig. 1A and Fig. 1B, a cooling system 1 includes a cooling intermediate composite body 100. A cooling intermediate composite body 100 includes a non-conductive bag 11 for enclosing an electronic apparatus 10 and a heat sink device 21. As described below, the heat sink device includes the thermal conductive base block placed inside the non-conductive bag and the thermal conductive outer block placed outside the non-conductive bag and fixed to the base block. The heat sink device, when combined with a base block and an outer block, may function as a heat radiator that can be thermally connected to the heat-generating element of the electronic apparatus, and may be generally made of copper or aluminum. Alternatively, it may also be advantageous to combine blocks made of heterogeneous metal materials, such as combination of a copper/aluminum outer block and an aluminum/aluminum base block. The base block of the heat sink device may be made of a plate-like member with a uniform thickness, for example. The outer block of the heat sink device may be made of a plate-like member including many plate-like or rod-like fins on its surface to increase the surface area, or a mere plate-like member, for example. Hereinafter, the present specification uses the terms "outer block," "upper outer block," "lower outer block," "base block," "upper base block," and "lower outer block." The term "block" included in these terms implies "plate" and "sheet," and does not limit the ratio between length and width or between diameter and height (or thickness) of the components, nor the shapes thereof.

The non-conductive bag 11 is made of a synthetic resin film (such as polyethylene, polypropylene, or polyester) that is water-resistant and relatively heat-resistant (100°C or more, for example) and can maintain hermeticity (airtightness/watertightness) when sealed as needed. A zipper mechanism 20 is provided for one side of the non-conductive bag 11. The zipper mechanism 20, when opened, enables the electronic apparatus 10 to be placed in the non-conductive bag 11 and, when closed, maintains hermeticity of the non-conductive bag 11. Additionally, a check valve 19 is provided for one surface of the non-conductive bag 11. The check valve 19 provides a path for vacuumizing inside the non-conductive bag 11 as needed, and maintains hermeticity during and after the vacuumization.

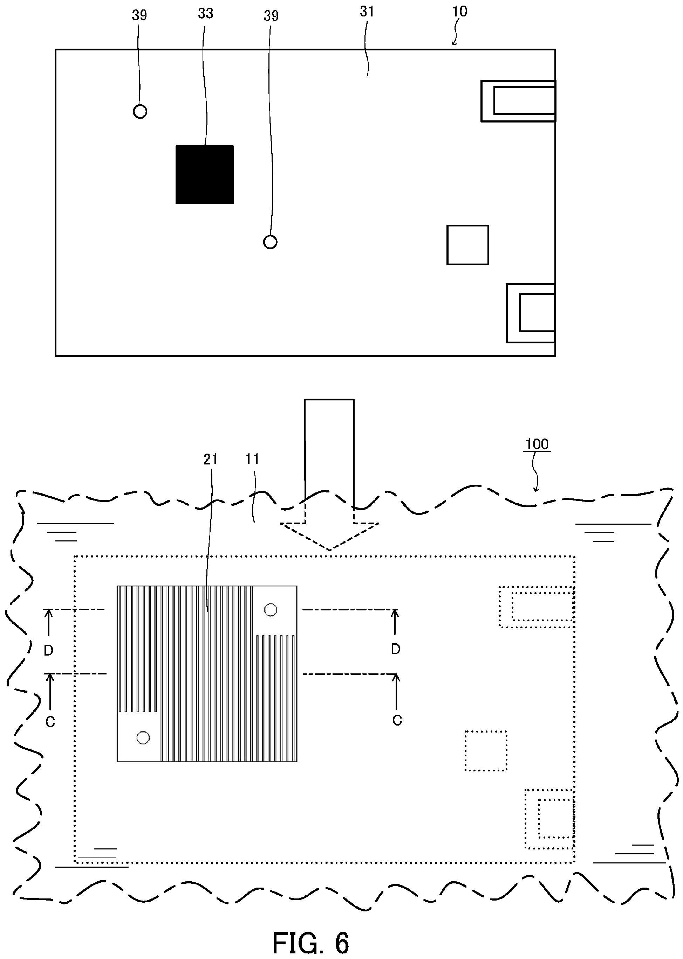

The electronic apparatus 10 includes a printed circuit board 31, at least one heat-generating element 33 (such as a CPU, as illustrated in Fig. 6 and elsewhere) mounted on the printed circuit board 31, and various electronic components 35, such as electrolytic capacitors. Each end of a network communication cable 36 and a power cable 37 is connected to the electronic apparatus 10 placed in the non-conductive bag 11 via connectors. The network communication cable 36 and the power cable 37 pass through penetration portions formed on one surface of the non-conductive bag 11. The penetration portion is provided with a sealing material 17. This makes it possible to connect the other ends of the network communication cable 36 and the power cable 37 to a network apparatus and a power distribution apparatus outside the non-conductive bag 11, while maintaining hermeticity of the non-conductive bag 11.

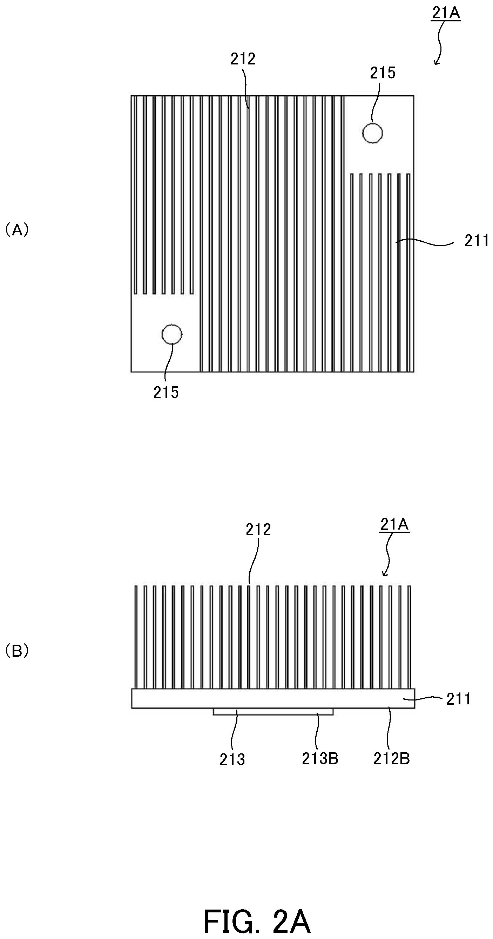

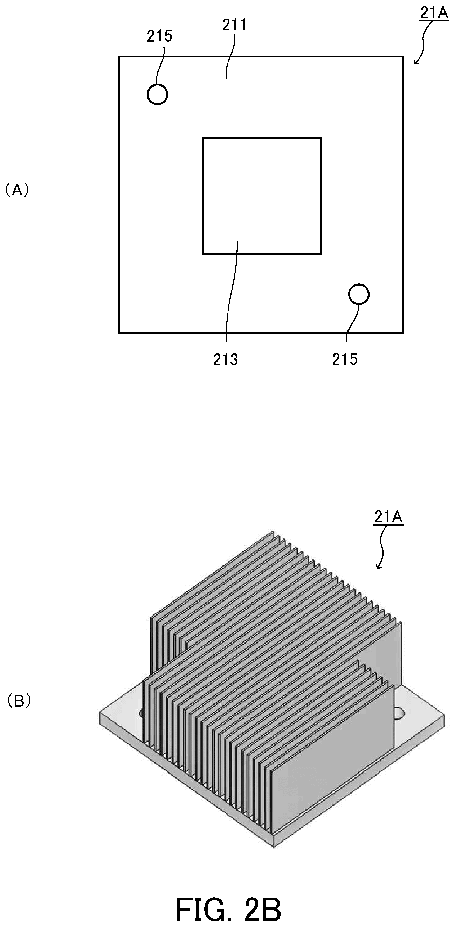

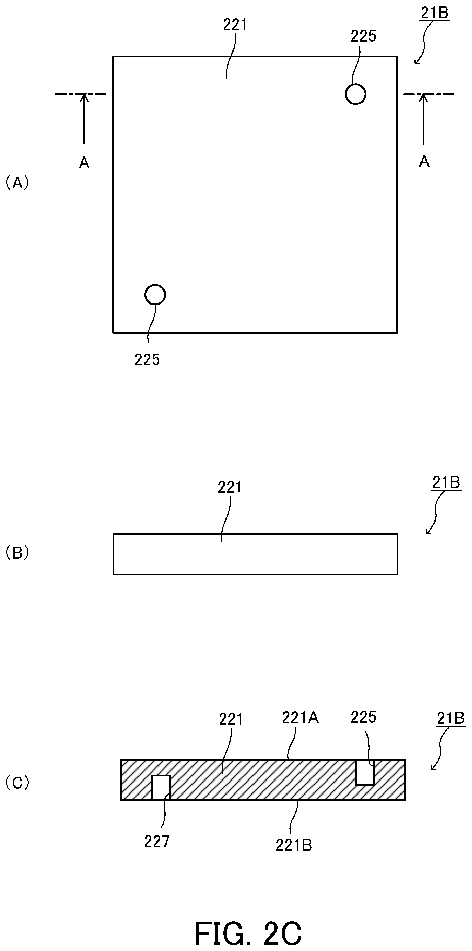

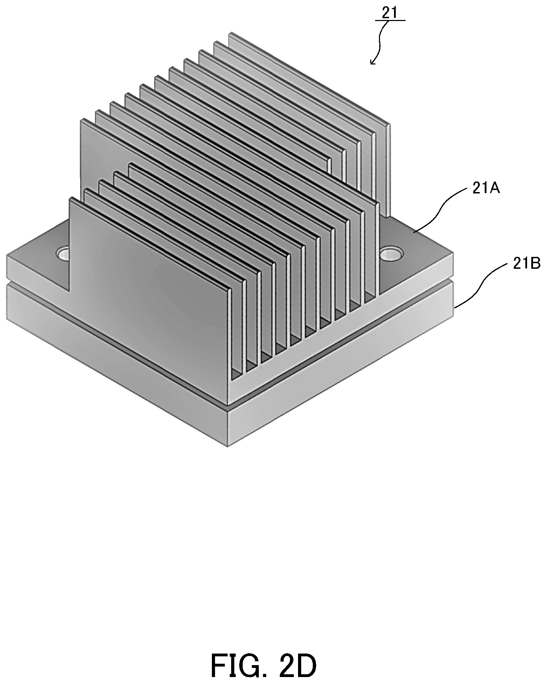

Figs. 2A and 2B illustrate an outer block 21A of the heat sink device 21 applied to the cooling intermediate composite body 100. Fig. 2A(A) is a plan view. Fig. 2A(B) is a front view. Fig. 2B(A) is a bottom view. Fig. 2B(B) is a perspective view. Figs. 2C and 2D illustrate a base block 21B of the heat sink device 21. Fig. 2C(A) is a plan view. Fig. 2C(B) is a front view. Fig. 2C(C) is a cross-sectional view taken along the line A-A of Fig. 2C(A). Fig. 2D is a perspective view of the heat sink device 21, including the outer block 21A and the base block 21B.

With reference to Fig. 2A and Fig. 2B, a fin area 212 on the surface of the outer block 21A includes many plate-shaped fins rising from a base 211. A pair of diagonally opposite regions on the surface of the base 211 is flat and includes no fins. Within each of these regions, a threaded hole 215, as a through hole, is formed to lead from the surface of the base 211 to the back surface. An elevated portion 213 is formed on the back surface of the base 211 of the outer block 21A. In this specification, a flat surface 212B without the elevated portion 213 is sometimes referred to as a "first back surface" of the outer block. A flat surface 213B placed at the top of the elevated portion 213 is sometimes referred to as a "second back surface" of the outer block. Either or both of the flat surfaces are sometimes referred to as "back surfaces" of the outer block.

By referencing Fig. 2C, a pair of diagonally located threaded holes 225 is formed on one flat surface 221A of the base block 21B, which is made of a rectangular plate-like member 221. A pair of threaded holes 227, located diagonally differently from the above, is formed on the other flat surface 221B of the base block 21B. In this specification, the flat surface 221A, where the threaded hole 225 is formed, is sometimes referred to as the surface of the base block. The flat surface 221B, where the threaded hole 227 is formed, is sometimes referred to as the back surface of the base block.

Fig. 2D illustrates the outer block 21A placed on the base block 21B so that the back surface 212B (second back surface) of the outer block 21A contacts the surface 221A of the base block 21B. As described below, this state also illustrates the appearance of the heat sink device 21 to be attached to an opening formed on the non-conductive bag 11.

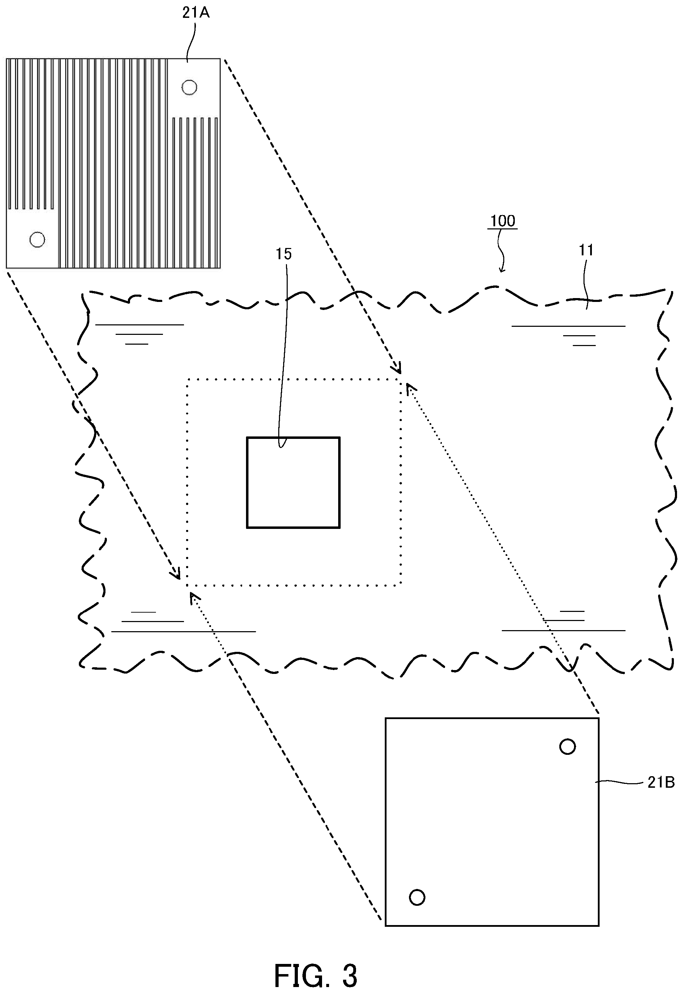

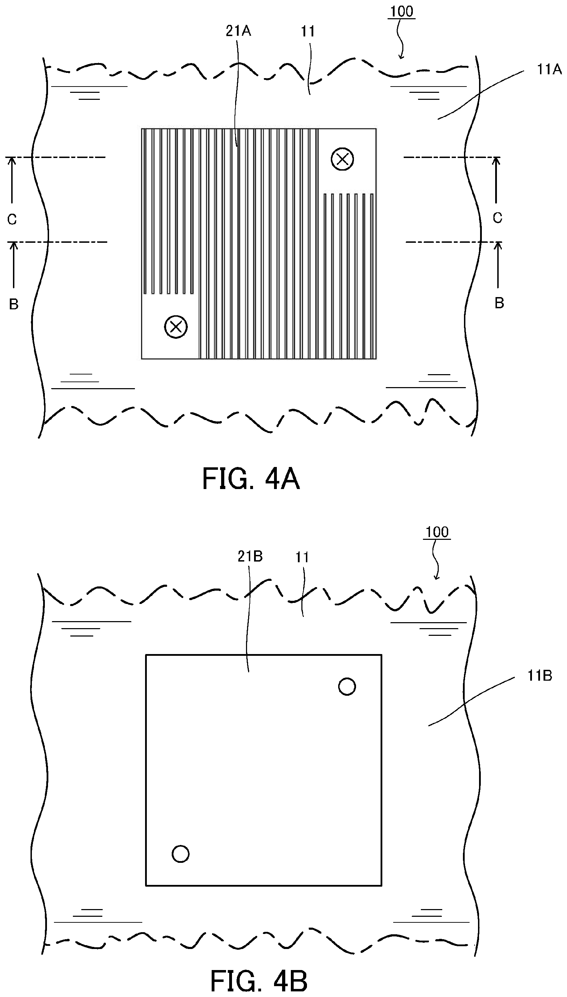

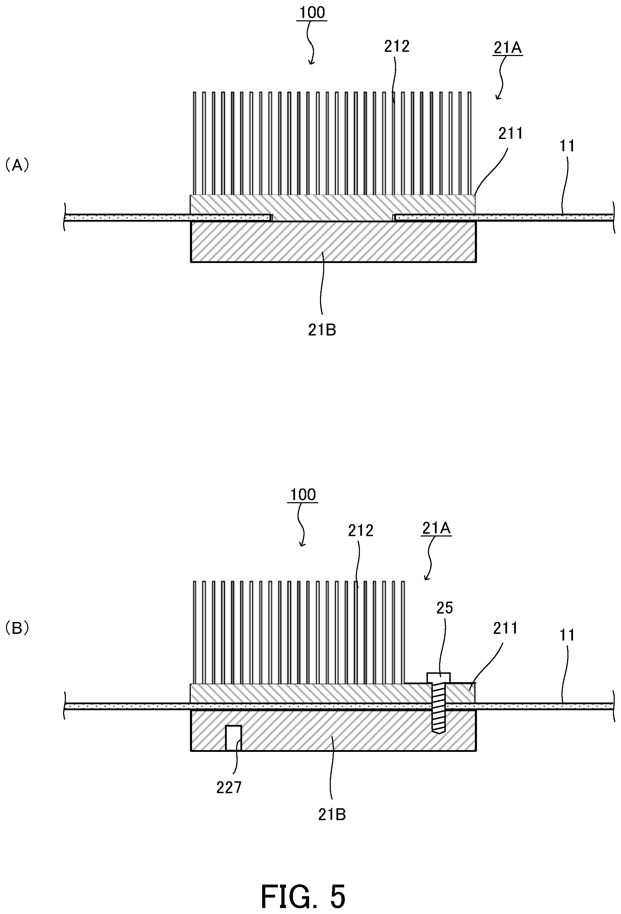

Fig. 3 illustrates the cooling intermediate composite body 100 disassembled into the components, such as the non-conductive bag 11, and the outer block 21A and the base block 21B of the heat sink device 21. Fig. 4A illustrates the cooling intermediate composite body 100 viewed from an exterior 11A of the non-conductive bag 11. Fig. 4B illustrates the cooling intermediate composite body 100 viewed from an interior 11B of the non-conductive bag 11. Fig. 5(A) illustrates a cross-sectional view taken along the line B-B of Fig. 4A. Fig. 5(B) illustrates a cross-sectional view taken along the line C-C of Fig. 4A. A first opening 15 is formed on the non-conductive bag 11. Preferably, the size (area) of the first opening 15 is similar to or slightly larger than the size (area) of the elevated portion 213 of the outer block 21A.

The outer block 21A can be fixed to the base block 21B using screws 25, for example. The flat surface 213B of the elevated portion 213 of the outer block 21A (or the second back surface of the outer block) contacts the surface 221A of the base block 21B through the first opening 15 in the non-conductive bag 11. Thus, the outer block 21A and the base block 21B are thermally connected. In addition, the flat surface 212B of the outer block 21A, namely, the first back surface of the outer block, and the surface 221A of the base block 21B apply an appropriate surface pressure to the region around the first opening 15 of the non-conductive bag 11. The appropriate surface pressure maintains watertightness on both sides of the surrounding area. The appropriate surface pressure can be achieved by appropriately adjusting the height of the elevated portion 213 according to the material and thickness of the non-conductive bag 11, for example. On the other hand, the back surface 221B of the base block 21B inside the non-conductive bag 11 provides a connecting surface that thermally connects to one side of the heat-generating element.

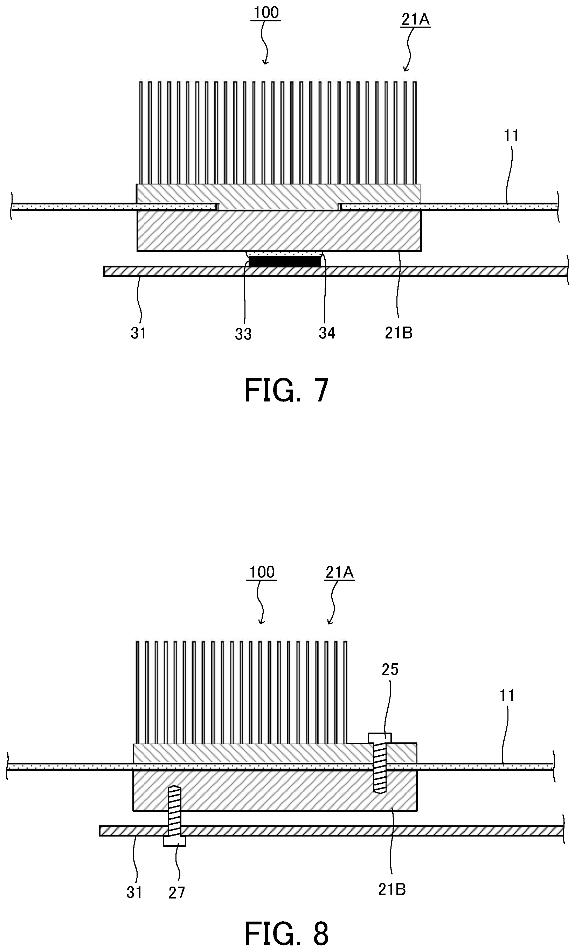

Fig. 6 illustrates an example of placing the electronic apparatus 10 in the cooling intermediate composite body 100. Fig. 7 is a cross-sectional view taken along the line C-C of Fig. 6. Fig. 8 is a cross-sectional view taken along the line D-D of Fig. 6. As illustrated in Fig. 6, the electronic apparatus 10 is placed in the cooling intermediate composite body 100. Then, as illustrated in Fig. 7, the printed circuit board 31 of the electronic apparatus 10 is fixed to the base block using a screw 27. One side of the heat-generating element 33 makes surface contact with and thermally connects with the back surface of the base block 21B of the heat sink device 21. To ensure the surface contact and thermal connection, it may be beneficial to fill a minute gap between one surface of the heat-generating element 33 and the back surface of the base block 21B with thermal conductive grease 34. After the electronic apparatus 10 is placed in the cooling intermediate composite body 100, the zipper mechanism of the non-conductive bag 11 is closed as needed. Then, the non-conductive bag 11 is vacuumized inside via the check valve 19. The vacuumization can allow the interior of the non-conductive bag to closely contact both sides of the printed circuit board and the surfaces of the various electronic components mounted on the printed circuit board. As described below, the zipper mechanism may remain partially open in some cooling system operation examples. In this case, even without vacuumization inside the bag, a cooling system operation allows the bag to be pressed by the hydraulic pressure of the surrounding coolant. The interior of the non-conductive bag can relatively closely contact both sides of the printed circuit board and the surfaces of various electronic components mounted on the printed circuit board.

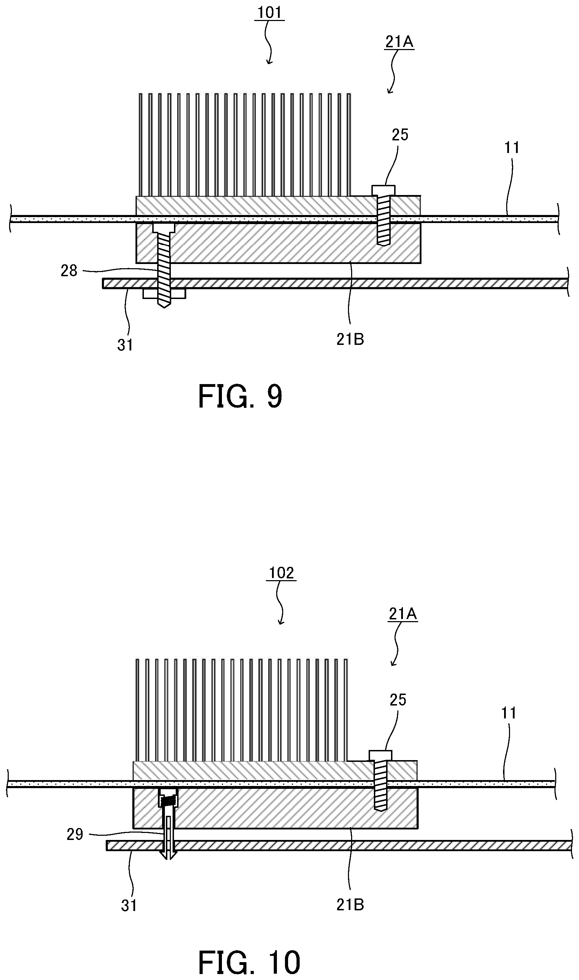

As illustrated in Figs. 2(C), 4B, 5B, and 8, the example of the PCB fixing mechanism fixes the printed circuit board 31 of the electronic apparatus 10 to the base block 21B in the cooling intermediate composite body 100. In this case, the screws 27 may be inserted from the side of the printed circuit board 31 into two or more threaded holes 227 mutually separately formed on the back surface of the base block 21B. Moreover, other PCB fixing mechanisms may be available. A cooling intermediate composite body 101 illustrated in Fig. 9 uses support screws 28 fixed into two or more screw support holes (through holes) mutually separately formed on the back surface of the base block 21B. The support screws can be inserted into the through holes in the printed circuit board 31 and fixed with nuts, for example. A cooling intermediate composite body 102 illustrated in Fig. 10 uses still another PCB fixing mechanism that fixes the heads of pushpins into two or more pushpin support holes mutually separately formed on the back surface of the base block 21B. The tips of the pushpins can be inserted into the through holes in the printed circuit board 31 for fixing. Here, a pushpin is a fastener as a combination of a half-split shaft barbed at the tip and a spring. It is known as a fastener for fastening members, such as printed circuit boards in the electronic apparatus, to other members, such as housings. A detailed explanation of the pushpin is omitted for brevity.

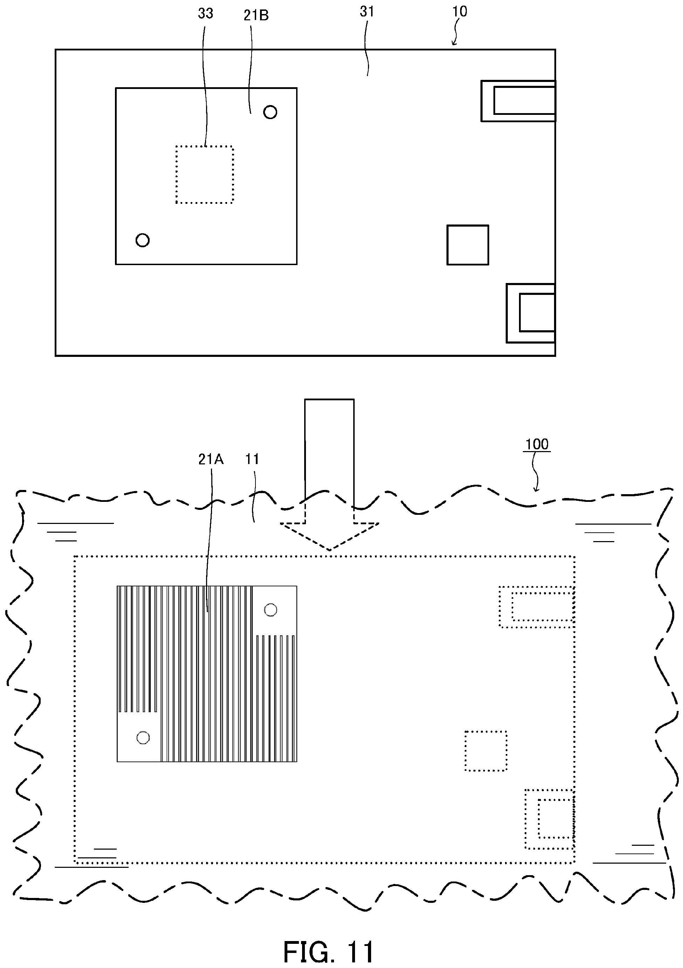

Fig. 11 illustrates another example of placing the electronic apparatus 10 in the cooling intermediate composite body 100. This placement method takes advantage of the heat sink device 21, divided into two components, the outer block 21A and the base block 21B. The difference from the placement method illustrated in Fig. 6 is that the base block 21B is fixed to the printed circuit board 31 of the electronic apparatus 10 before the process of fixing the outer block 21A and the base block 21B. Upon completion of the process of fixing to the printed circuit board, the back surface 221B of the base block 21B is thermally connected to one side of the heat-generating element.

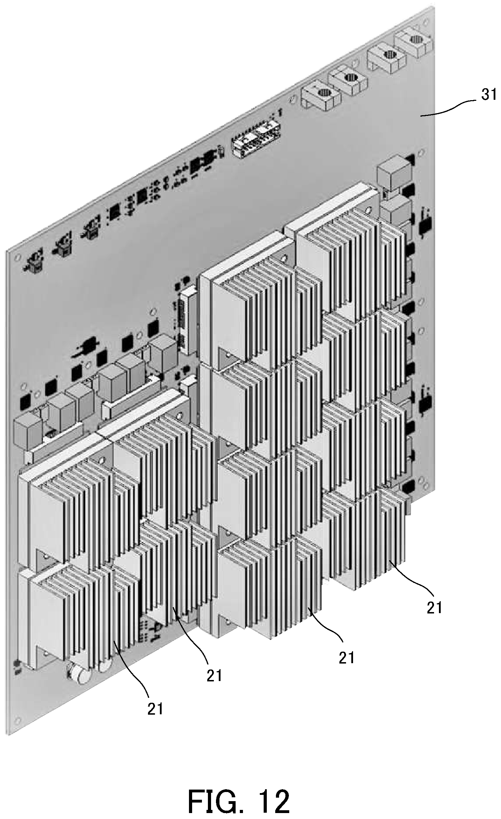

Fig. 12 is a perspective view illustrating a plurality of heat sink devices 21 mounted on the printed circuit board 31 of an electronic apparatus that is highly densely mounted with the plurality of the semiconductor devices (non-conductive bag unshown). In this example, 12 processors are mounted on the printed circuit board 31. One heat sink device 21 is fixed to each processor. This is a mere example. Other examples appropriate for cooling an electronic apparatus highly densely mounted with the plurality of the semiconductor devices or an electronic apparatus mounted with large semiconductor devices will be described later.

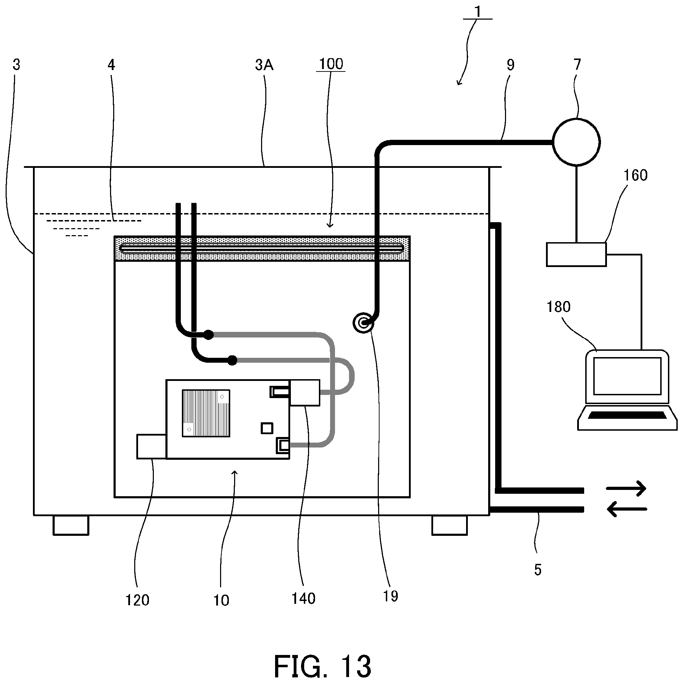

Fig. 13 is a diagram illustrating an operation of the cooling system 1. A cooling tank 3 contains a sufficient amount of coolant 4 to immerse the cooling intermediate composite body 100. The coolant 4 can be ordinary water (such as tap water, industrial water, or seawater). Piping 5 connected to the cooling tank 3 provides a path that discharges the coolant heated in the cooling tank 3 and returns the coolant cooled by a heat exchanger (not shown) to the cooling tank 3. When the cooling intermediate composite body 100 is immersed in the coolant 4, the coolant 4 directly removes heat from the surface of the outer block 21A of the heat sink device 21 (or dissipates heat from the outer block 21A). The base block 21B of the heat sink device 21 locally and powerfully removes heat from the heat-generating element 33, which is thermally connected to the back surface of the base block 21B. Conventional cooling methods had problems that coatings or bags covering electronic apparatuses or semiconductor devices inhibit heat transfer between the heat-generating element and the coolant or the flow of coolant. It is now possible to solve these problems and improve the cooling performance of electronic apparatuses. The non-conductive bag 11 can be sealed inside and then vacuumized, as needed, to allow the interior of the non-conductive bag 11 to closely contact both sides of the printed circuit board 31 and the surfaces of the various electronic components 35 mounted on the printed circuit board 31. Thereby, it is possible to increase the efficiency of heat removal from the various electronic components 35 and further improve the cooling performance of the electronic apparatus 10.

An operation example of the cooling system 1 may immerse the watertight part of the cooling intermediate composite body 100 in the coolant 4 while the non-conductive bag 11 is at least partially watertight. For example, the zipper mechanism 20 of the non-conductive bag 11 may remain partially open instead of being fully zipped. Then, the cooling intermediate composite body 100 is immersed in the coolant 4 so that the zipper mechanism 20 is positioned above the liquid level of the coolant 4. The bag is then pressed by the surrounding coolant pressure to discharge the air from the bag to the outside. Concurrently, the interior of the non-conductive bag can relatively closely contact both sides of the printed circuit board and the surfaces of various electronic components mounted on the printed circuit board.

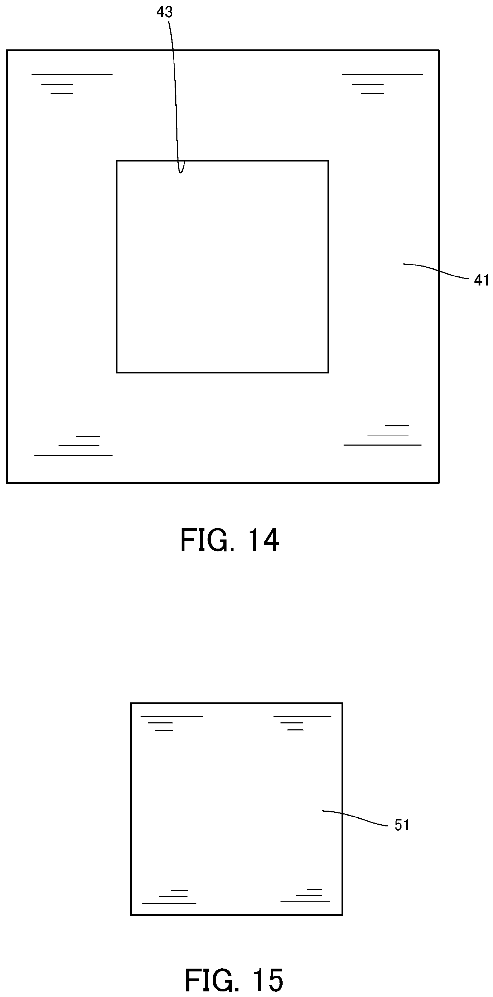

Next, by referencing Figs. 14 to 26, the following describes other examples of placing the electronic apparatus in the cooling intermediate composite body. Various variations are available for placing the electronic apparatus in the partially modified cooling intermediate composite body. Parts similar to those in Figs. 1A through 11 use similar reference numerals.

Fig. 14 is a plan view illustrating a bonding layer that can be used in other examples of placing the electronic apparatus in the cooling intermediate composite body. As described below, a heterogeneous-material bonding film, double-sided adhesive tape, or watertight packing is used to form a bonding layer that connects the surface of the base block to the interior of the non-conductive bag, or the back surface of the outer block to the exterior of the non-conductive bag. A second opening 43 is formed on a bonding layer 41 made of the heterogeneous-material bonding film, double-sided adhesive tape, or watertight packing. In the illustrated example, the size of the bonding layer 41 is preferably slightly larger than or equal to the size of the back surface of the outer block or the size of the surface of the base block. The size of the second opening 43 is preferably slightly larger than or equal to the size of the elevated portion of the base block. Specific examples of the heterogeneous-material bonding film, double-sided adhesive tape, or watertight packing that form the bonding layer 41, as well as methods for forming the bonding layer, are described below.

Fig. 15 is a plan view illustrating a thermal conductive sheet that can be used for other examples of similarly mounting an electronic apparatus on the cooling intermediate composite body. A thermal conductive sheet 51 may be made of a highly thermal conductive resin, ceramic, or metal sheet, or a resin or ceramic sheet containing a metal filler. The size of the thermal conductive sheet 51 is preferably slightly smaller than or equal to the size of the second opening 43 formed on the heterogeneous-material bonding film 41. The use of the thermal conductive sheet and other configurations that can be alternatives to the thermal conductive sheet will be described later.

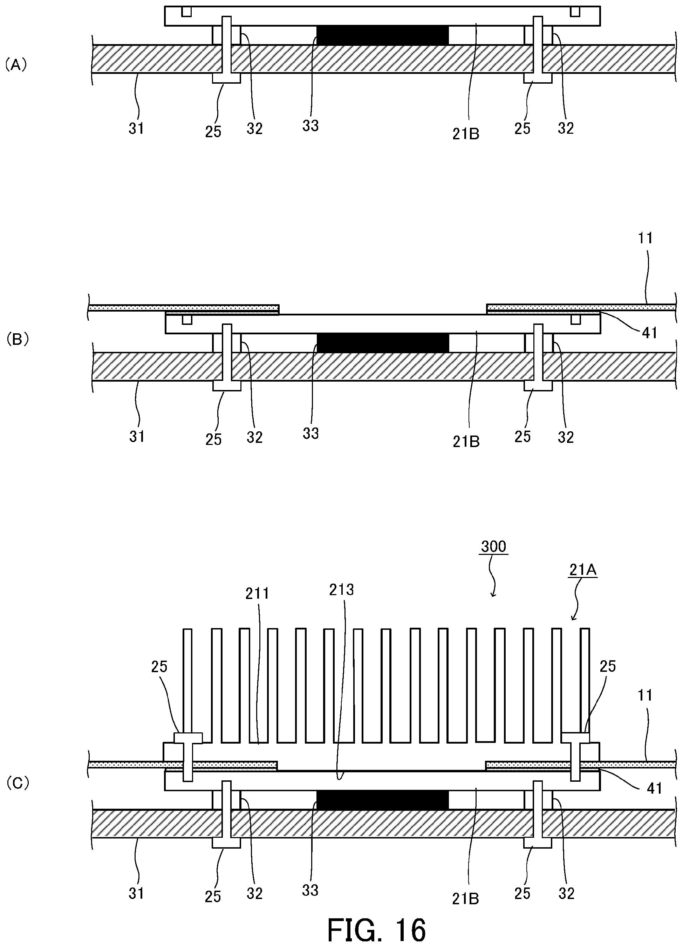

Fig. 16 to Fig. 27 are schematic cross-sectional views illustrating another example of mounting the electronic apparatus on the cooling intermediate composite body. For ease of illustration, the schematic cross-sectional views in Fig. 16 and subsequent drawings combine a cross-section along the center of the heat sink device with a cross-section along lines that pass through near four corners of the heat sink device and the centers of the plurality of the screws attached to the four corners. The cross-sections of the heat sink device, screws, and their accessories are intentionally not shaded.

The other examples are described below in order. A cooling intermediate composite body 300 illustrated in Fig. 16(C) differs from the cooling intermediate composite body 100 illustrated in Figs. 2 through 8 and 11 in the following ways. The outer block 21A and base block 21B (as well as the elevated portion 213) of the heat sink device 21 are increased in width to conform to the larger-sized heat-generating element 33 mounted on the printed circuit board 31. The base block 21B is fixed to the printed circuit board 31 using the screws 25 with intervening spacers 32. The bonding layer 41 is included to connect the surface of the base block 21B with the interior of the non-conductive bag 11.

By referencing Fig. 16, the following describes procedures to configure the cooling intermediate composite body 300. First, the base block 21B is fixed to the printed circuit board 31 using the screws 25 with the intervening spacers 32 (Fig. 16(A)). The spacer 32 may be as high as the heat-generating element 33. When screwed, the back surface of the base block 21B is thermally connected to the surface of the heat-generating element. The spacer 32 prevents the base block 21B from moving downward due to overtightening the screws or an external force applied to the base block 21B during processes after the screwing, thereby helping to prevent damage to the heat-generating element.

The heterogeneous-material bonding film 41 and then the non-conductive bag 11 are placed in order on the surface of the base block 21B. The first opening of the bag 11 and the second opening of the heterogeneous-material bonding film 41 are aligned to overlap each other. The heterogeneous-material bonding film is processed using thermocompression bonding, for example, to provide the bonding layer 41. The surface of the base block 21B is bonded to the region around the first opening of the bag 11 (Fig. 16(B)).

Examples of heterogeneous-material bonding films usable for forming the bonding layer 41 include "Metaseal" (a Fujimori Kogyo product name) series manufactured by Fujimori Kogyo Co., Ltd. This heterogeneous-material bonding film, formed into a film of uniform thickness, is sandwiched between the surface of the base block 21B and the interior of the non-conductive bag 11. Then, the thermocompression bonding is performed. A bonding layer can be formed to bond the base block 21B and the non-conductive bag 11. A heat press or iron-type heater can be used for thermocompression bonding to complete the bonding process between the base block 21B and the non-conductive bag 11 easily and quickly (several seconds or more). The method for forming the bonding layer 41 is not limited to thermocompression bonding, but may include various methods, such as pressure, ultrasonic waves, electromagnetic waves, and light irradiation.

The bonding layer 41 formed of the heterogeneous-material bonding film enables surface bonding between the surface of the base block 21B and the interior of the non-conductive bag 11, while ensuring no variations in adhesive strength and a uniform film thickness. This enables the appropriate use for firm bonding between the heat sink and the bag.

The other examples of heterogeneous-material bonding films usable for forming the bonding layer 41 include "WelQuick" (a Resonac Corporation product) manufactured by Resonac Corporation. This heterogeneous-material bonding film uses the solid-liquid phase change of the film material to be able to not only complete a bonding process in a short time (several seconds) but also peel and reattach the film by reheating after bonding. It is possible to facilitate the recovery of the cooling intermediate composite body 300 from a cooling system after a certain period of use, as well as peeling of the base block 21B from the non-conductive bag 11, resulting in high resource reusability.

The heterogeneous-material bonding film can be previously formed into a sheet or film and cut for appropriate use. Alternatively, it may be advantageous to start from a liquid or gel adhesive material and form the heterogeneous-material bonding film into a bonding layer 23 under a specified environment, if available, that can appropriately control various conditions, including film thicknesses and shapes, for example. As a specific example, a mold is first placed on the surface of the base block 21B and is filled with a liquid or gel adhesive material. This makes it possible to form a coating film of adhesive material, satisfying the intended shape (including the first opening in the center) and volume, on the surface of the base block 21B. The method of heat-press bonding, pressure, ultrasonic waves, electromagnetic waves, or light irradiation, for example, can then harden the coating film made of the adhesive material in contact with the heat sink surface and the interior of the non-conductive bag. Consequently, it is possible to provide the bonding layer formed of the heterogeneous-material bonding film, starting from a liquid or gel adhesive material.

The surface of the base block 21B is bonded to the region around the first opening of the bag 11 via the bonding layer 41. Thereafter, the outer block 21A is then placed on the base block 21B from the exterior side of the bag 11 and is fixed using screws 25 (Fig. 16(C)). In the fixed condition, the flat surface of the elevated portion 213 of the outer block 21A makes contact with and thermally connects to the surface of the base block 21B. On the other hand, the flat surface around the elevated portion 213 of the outer block 21A applies a moderate surface pressure to the region around the first opening of the bag 11. This moderate surface pressure (as well as the intervening bonding layer 41 inside the bag) maintains watertightness on both sides of the surrounding region.

Alternatively, the bonding layer may be formed of double-sided adhesive tape. For example, a double-sided adhesive tape for the bonding layer can be prepared by cutting a high-strength acrylic foam tape (such as "3M VHB Tape," 3M's product name) to an intended size and shape. One side of the double-sided adhesive tape is pressed against and adhered to the surface of the base block 21B or the interior of the non-conductive bag 11. Then, the interior of the non-conductive bag 11 or the surface of the base block 21B is pressed against and adhered to the other side of the double-sided adhesive film. The bonding layer can thereby be formed to bond between the base block 21B and the non-conductive bag 11. The use of double-sided adhesive tape has the advantage of eliminating heat treatment and therefore facilitating the formation of the bonding layer. It is advantageous to arrange the cut double-sided adhesive tape so that the bonding layer forms a continuous, closed band surrounding the first opening of the bag 11.

Alternatively, the bonding layer may be formed of a watertight packing. For example, it is possible to use various rubber packings formed into a continuous, closed band or line, such as O-rings, typically. The watertight packing is placed between the surface of the base block 21B and the interior of the non-conductive bag 11 to surround the first opening of the bag 11. Then, the outer block 21A is placed on the base block 21B from the exterior side of the bag 11 and is fixed using screws 25. In this fixed condition, the watertight packing elastically deforms and applies a moderate surface pressure zonally or lineally to the region around the first opening 15 of the bag 11. It is possible to maintain watertightness on both sides of the surrounding region.

It is obvious to select the large-sized heat sink device 21 when the heat-generating element 33 is large-sized or indicates high heat values. The heat sink device can be divided into components such as the outer block 21A and the base block 21B. Later on, the outer block 21A alone can be replaced with a different outer block with different thermal properties, such as a different fin configuration and/or block material. This can improve convenience. For example, after the electronic apparatus starts operation in a data center, there may be a case where the heat value of the heat-generating element 33 is found to significantly deviate from the original design value for some reason. In such a case, the outer block 21A alone can be removed from the cooling intermediate composite body 300 at a later time and replaced with another outer block that differs in thermal properties (the fin height or the number of fins, the overall fin surface area, or heat dissipation performance due to different block materials, for example). There is no need to remove the bag 11 from the base block 21B or the base block 21B from the printed circuit board 31. It is possible to simplify the replacement process and avoid the risk of losing the watertightness of the cooling intermediate composite body 300 due to the replacement process.

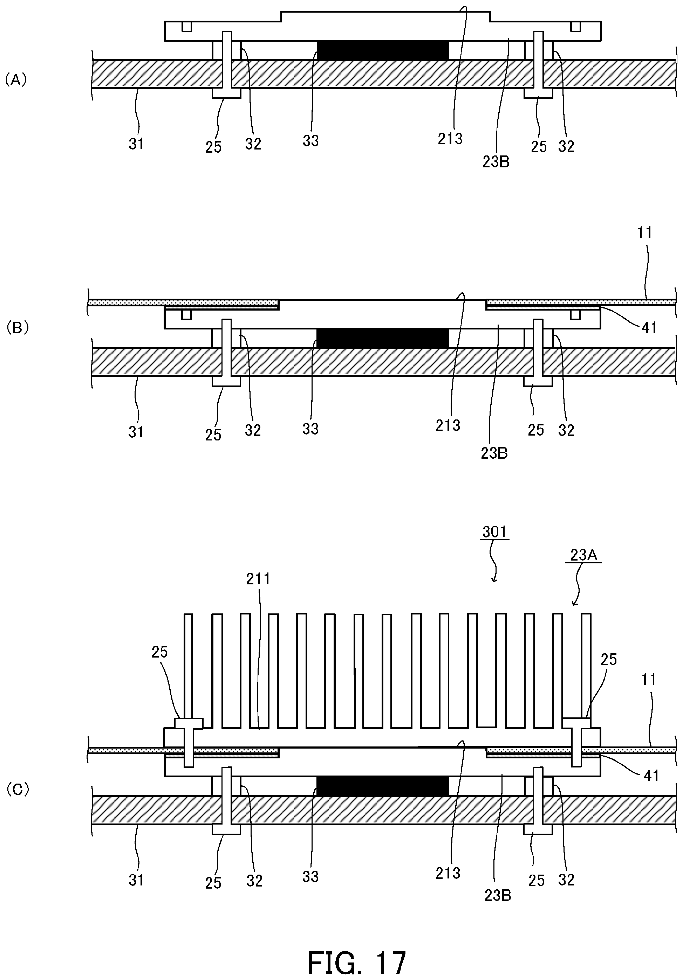

Fig. 17 is a schematic cross-sectional view illustrating still another example of mounting the electronic apparatus on the cooling intermediate composite body. The cooling intermediate composite body 301 differs from the cooling intermediate composite body 300 illustrated in Fig. 16 in the use of an outer block 23A with a flat back surface and a base block 23B with an elevated portion 213 formed on its surface. The procedure for configuring the cooling intermediate composite body 301 is similar to that for configuring the cooling intermediate composite body 300, except that the second opening in the heterogeneous-material bonding film 41 and the first opening in the bag 11 are aligned with the elevated portion 213 on the surface of the base block 21B. Detailed description is omitted here.

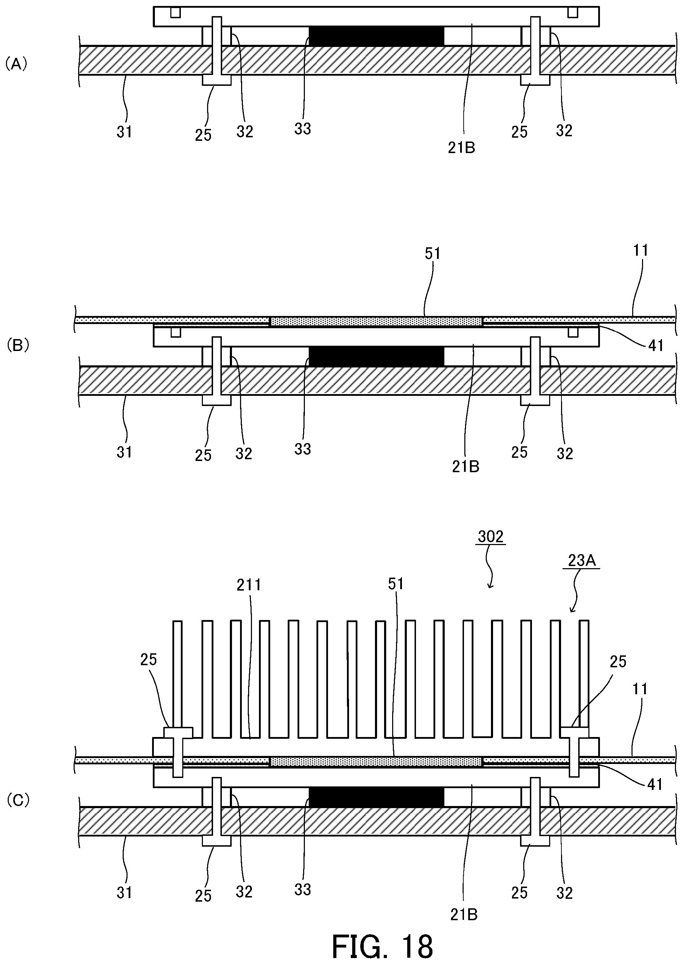

Fig. 18 is a schematic cross-sectional view illustrating still another example of mounting the electronic apparatus on the cooling intermediate composite body. The cooling intermediate composite body 302 differs from the cooling intermediate composite body 300 illustrated in Fig. 16 in the following ways. The outer block 23A with a flat back surface and the base block 21B with a flat surface are used. The thermal conductive sheet 51 is placed to fill the second opening in the heterogeneous-material bonding film 41 and the first opening in the bag 11. The back surface of the outer block 23A contacts the surface of the base block 21B via the thermal conductive sheet 51. The thermal conductive sheet 51 may be replaced with thermal conductive grease. This configuration of the cooling intermediate composite body 302 can also ensure a heat transfer path from the base block 21B to the outer block 23A.

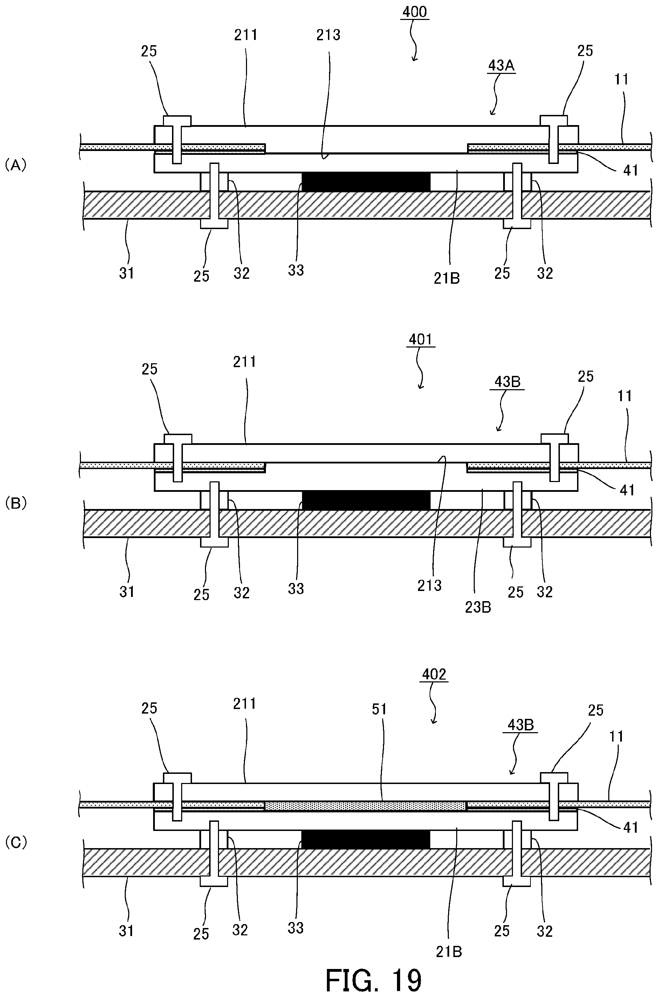

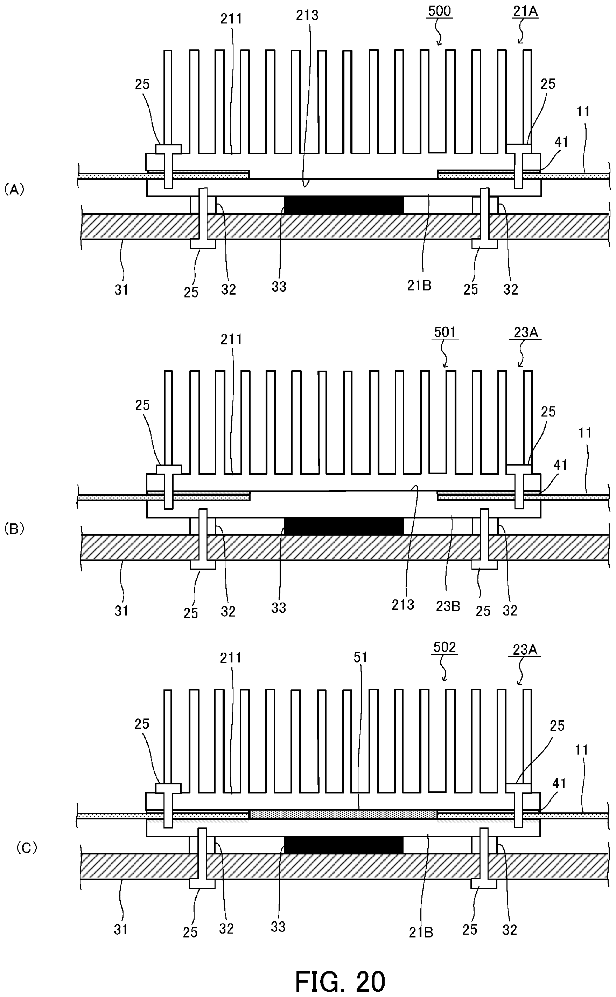

Fig. 19 is a schematic cross-sectional view illustrating yet other three examples of mounting the electronic apparatus on the cooling intermediate composite body. A cooling intermediate composite body 400 according to the example in Fig. 19(A) differs from the cooling intermediate composite body 300 illustrated in Fig. 16, a cooling intermediate composite body 401 according to the example in Fig. 19(B) differs from the cooling intermediate composite body 301 illustrated in Fig. 17, and a cooling intermediate composite body 402 according to the example in Fig. 19(C) differs from the cooling intermediate composite body 302 illustrated in Fig. 18 in the following ways. An outer blocks 43A and 43B have flat surfaces and no fins. A plate-shaped outer block with no fins may be used when the thermal design does not require a large surface area for the outer block. The same also applies to the other examples illustrated in Figs. 20 through 26 below.

Fig. 20 is a schematic cross-sectional view illustrating yet other three examples of mounting the electronic apparatus on the cooling intermediate composite body. A cooling intermediate composite body 500 according to the example in Fig. 20(A) differs from the cooling intermediate composite body 300, a cooling intermediate composite body 501 according to the example in Fig. 20(B) differs from the cooling intermediate composite body 301, and a cooling intermediate composite body 402 according to the example in Fig. 20(C) differs from the cooling intermediate composite body 302 in the following ways. The heterogeneous-material bonding film 41 is placed between the back surface of the outer block 21A/23A and the exterior of the non-conductive bag 11. The bonding layer bonds the back surface of outer block 21A/23A and the exterior of non-conductive bag 11.

The following outlines example procedures for configuring the cooling intermediate composite bodies 500, 501, and 502. First, the base block 21B/23B is fixed to the printed circuit board 31 using screws 25 and intervening spacers 32. With the back surface of the outer block 21A/23A facing up, the heterogeneous-material bonding film 41 is placed on top of it, and the non-conductive bag 11 is then placed on top of it. The bonding layer, formed of the heterogeneous-material bonding film, bonds the back surface of the outer block 21A/23A and the exterior of the non-conductive bag 11. The printed circuit board 31 with the base block is placed inside the bag. The outer block 21A/23A with the bag is placed on top of the base block 21B/23B and fixed using screws 25. This configuration can also maintain watertightness on both sides of the region around the first and second openings due to a moderate surface pressure applied by the flat back surface of the base block (as well as intervention of the bonding layer 41 outside the bag).

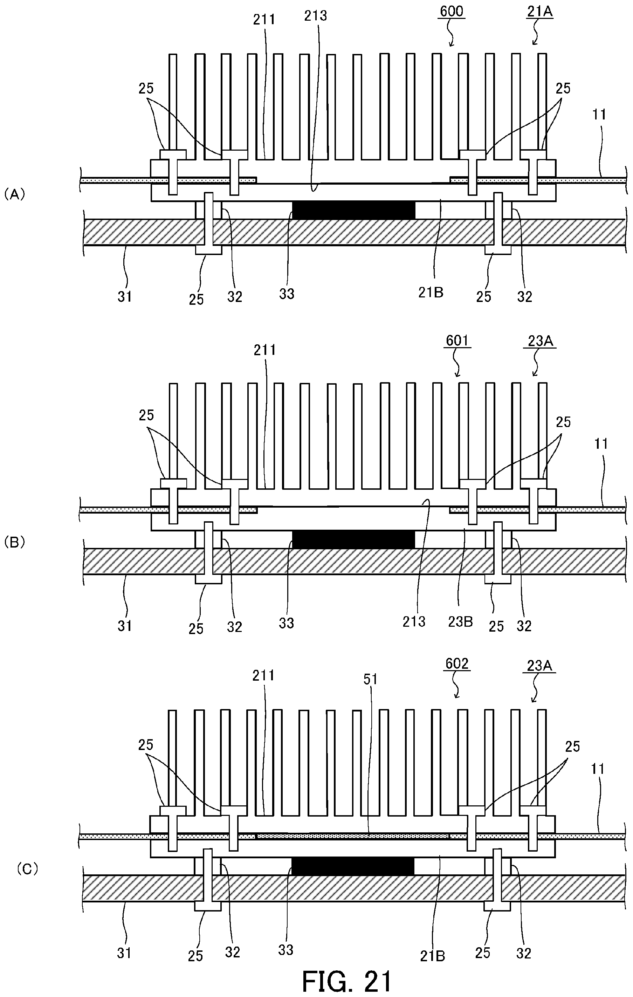

Fig. 21 is a schematic cross-sectional view illustrating yet other three examples of mounting the electronic apparatus on the cooling intermediate composite body. A cooling intermediate composite body 600 according to the example in Fig. 21(A) differs from the cooling intermediate composite body 300, a cooling intermediate composite body 601 according to the example in Fig. 21(B) differs from the cooling intermediate composite body 301, and a cooling intermediate composite body 602 according to the example in Fig. 21(C) differs from the cooling intermediate composite body 302 in the following ways. No heterogeneous-material bonding film is used. As already explained about the cooling intermediate composite body 100, this configuration can also maintain watertightness on both sides of the region around the first opening of the non-conductive bag 11.

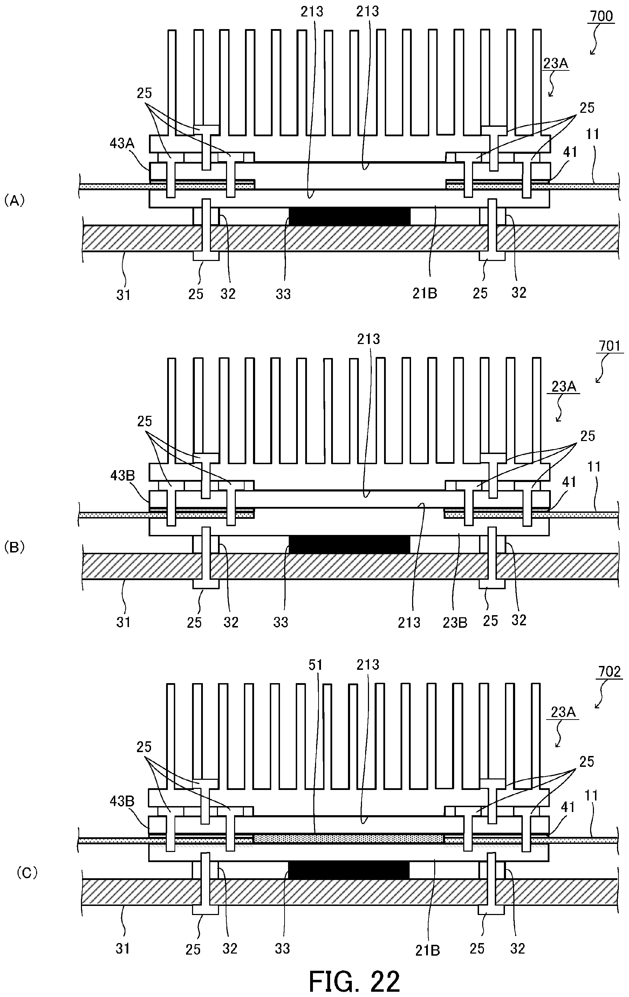

Fig. 22 is a schematic cross-sectional view illustrating yet other three examples of mounting the electronic apparatus on the cooling intermediate composite body. A cooling intermediate composite body 700 according to the example illustrated in Fig. 22(A) differs from the cooling intermediate composite body 500 illustrated in Fig. 20(A), a cooling intermediate composite body 701 according to the example illustrated in Fig. 22(B) differs from the cooling intermediate composite body 501 illustrated in Fig. 20(B), and a cooling intermediate composite body 602 according to the example illustrated in Fig. 22(C) differs from the cooling intermediate composite body 502 illustrated in Fig. 20(C) in the following ways. The outer block includes a thermal conductive lower outer block 43A/43B and a thermal conductive upper outer block 23A that is thermally connected to and fixed to the surface of the lower outer block 43A/43B. When the lower outer block 43A/43B is fixed to the base block 21B/23B, the back surface of the lower outer block 43A/43B and the surface of the base block 21B/23B maintain watertightness on the region around the first opening in the non-conductive bag and the region around the second opening in the bonding layer. According to this configuration, the upper outer block can have the function of external heat dissipation. The lower outer block and the upper base block can have the functions of maintaining watertightness in the region around the first opening in the non-conductive bag and transferring heat through the opening. The base block can have the functions of removing heat from and protecting the heat-generating element.

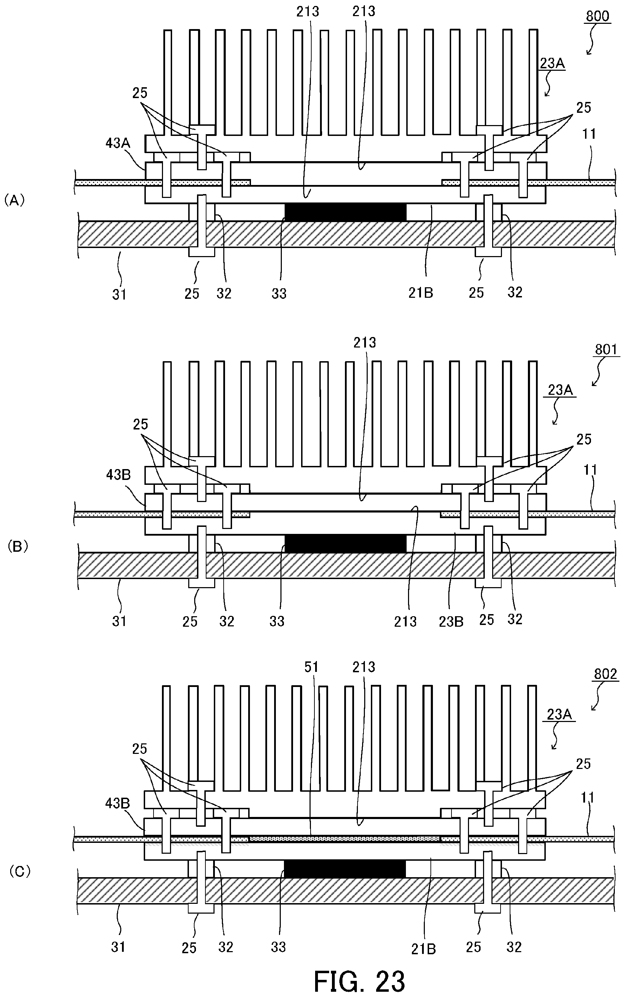

Fig. 23 is a schematic cross-sectional view illustrating yet other three examples of mounting the electronic apparatus on the cooling intermediate composite body. A cooling intermediate composite body 800 according to the example in Fig. 23(A) differs from the cooling intermediate composite body 700, a cooling intermediate composite body 801 according to the example in Fig. 23(B) differs from the cooling intermediate composite body 701, and a cooling intermediate composite body 802 according to the example in Fig. 23(C) differs from the cooling intermediate composite body 702 in the following ways. No heterogeneous-material bonding film is used. This configuration can also maintain watertightness on both sides of the region around the first opening of the non-conductive bag 11.

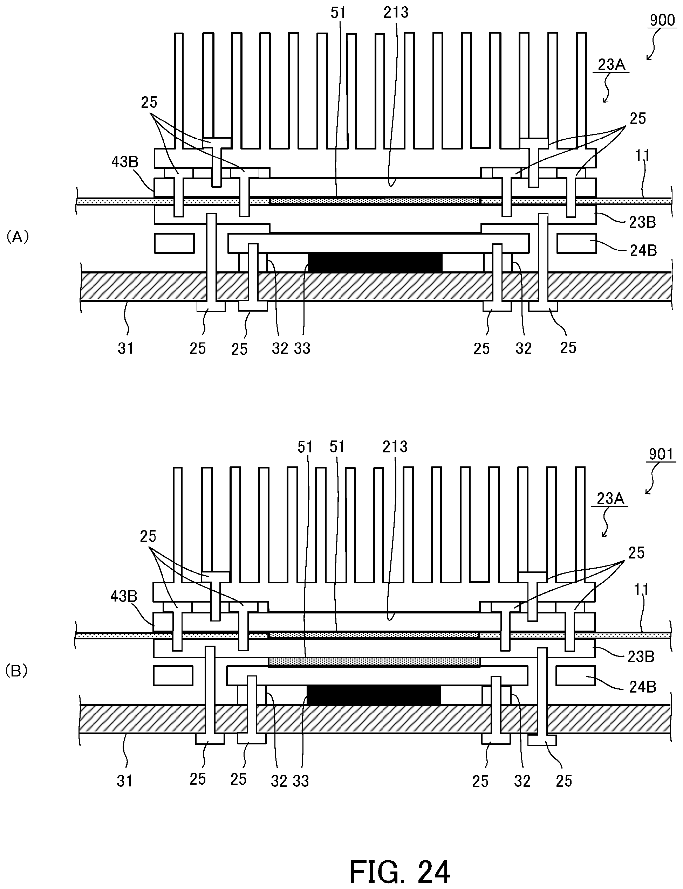

Fig. 24 is a schematic cross-sectional view illustrating yet other two examples of mounting the electronic apparatus on the cooling intermediate composite body. A cooling intermediate composite body 900 according to the example in Fig. 24(A) differs from the cooling intermediate composite body 802 illustrated in Fig. 23(C), and a cooling intermediate composite body 901 according to the example in Fig. 24(B) differs from the cooling intermediate composite body 802 in the following ways. The base block includes a thermal conductive lower base block 24B and a lower base block 24B. An elevated portion formed on the back surface of the upper base block 23B contacts and is thermally connected to the surface of the lower base block 24B. Alternatively, the back surface of the upper base block 23B is thermally connected to the surface of the lower base block 24B via the thermal conductive sheet 51. According to this configuration, the upper outer block 23A can have the external heat dissipation function. The lower outer block 43B and the upper base block 23B can have the watertightness maintenance and heat transfer functions. The lower base block 24B can have the heat removal and protection functions.

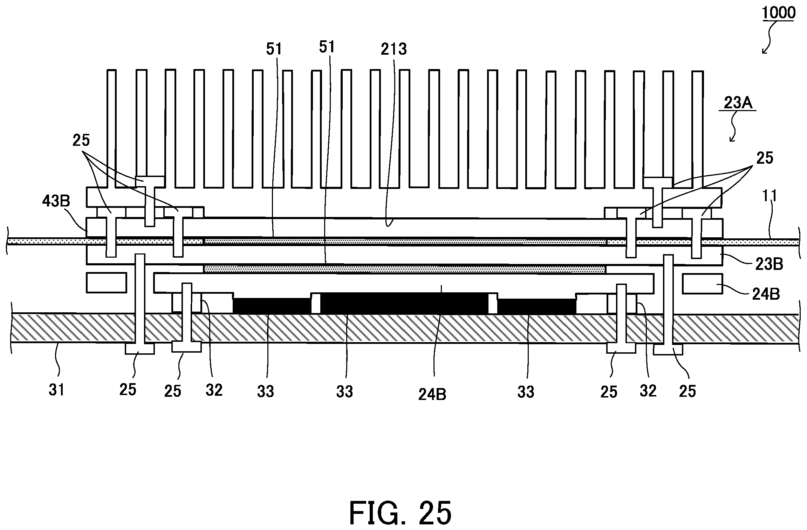

Fig. 25 is a schematic cross-sectional view illustrating still another example of mounting the electronic apparatus on the cooling intermediate composite body. A cooling intermediate composite body 1000 according to the example in Fig. 25 differs from the cooling intermediate composite body 901 illustrated in Fig. 24(B) in the following ways. The upper outer block 23A, the lower outer block 43B, the upper base block 23B, and the lower base block 24B are wider and larger in size to conform to a large semiconductor device whose heterogeneous integration structure uses the plurality of the heat-generating elements (semiconductor chips) 33 of different surface heights. The plurality of the convex surfaces of different heights are formed on the back surface of the lower base block 24B. Consequently, it is possible to ensure thermal connection to the plurality of the heat-generating elements 33 by appropriately processing the back surface of the lower base block and then assembling the whole without modifying the upper base block.

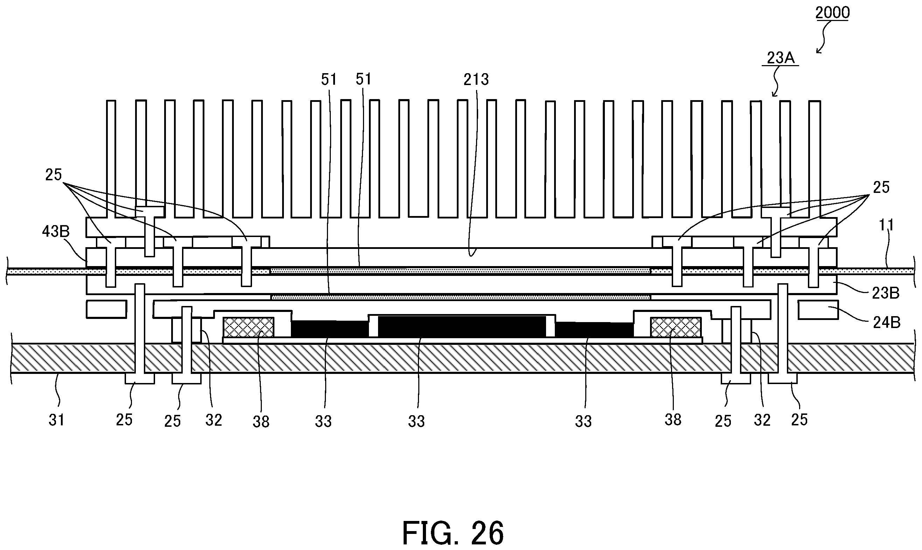

Fig. 26 is a schematic cross-sectional view illustrating still another example of mounting the electronic apparatus on the cooling intermediate composite body. A cooling intermediate composite body 2000 according to the example in Fig. 25 differs from the cooling intermediate composite body 1000 illustrated in Fig. 25 in the following ways. A large semiconductor device based on the heterogeneous integration structure includes a metal frame (hereinafter referred to as a "stiffener") 38 to entirely surround the plurality of the heat-generating elements (semiconductor chips). The upper outer block 23A, the lower outer block 43B, the upper base block 23B, and the lower base block 24B are wider and larger in size to conform to a larger semiconductor device. This example forms the plurality of the convex surfaces of different heights on the back surface of the lower base block 24B. In addition, a concave surface is formed on the back surface of the lower base block 24B at a position corresponding to the stiffener 38, ensuring the conformity to printed circuit boards mounted with stiffener-equipped semiconductor devices.

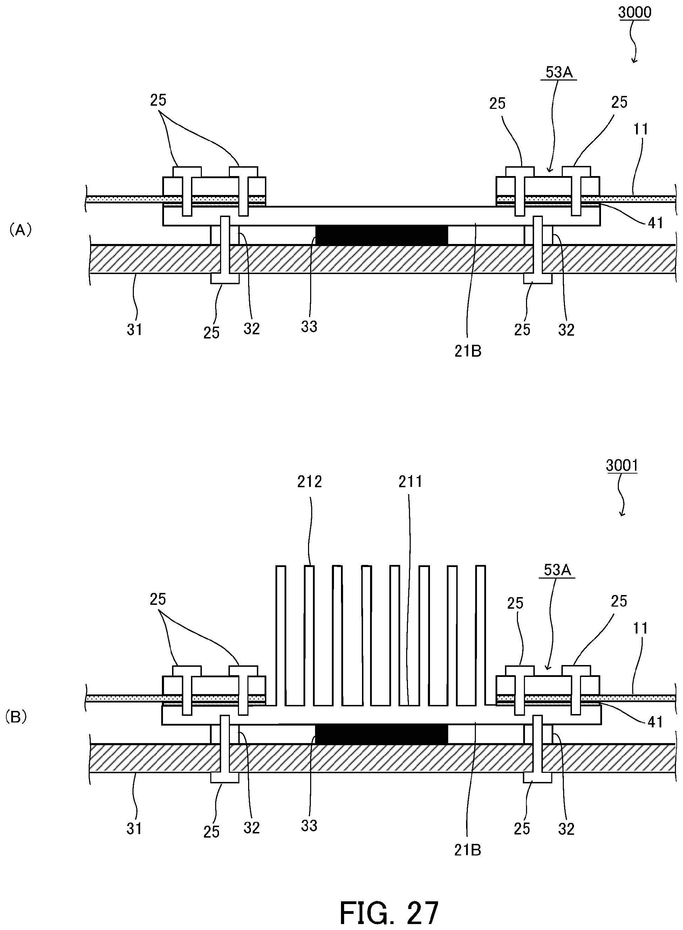

Fig. 27 is a schematic cross-sectional view illustrating still another example of mounting the electronic apparatus on the cooling intermediate composite body. A cooling intermediate composite body 3000 according to the example in Fig. 27(A) is similar to the cooling intermediate composite body 402 illustrated in Fig. 19(C) in that an outer block 53A has a plate-like structure without fins. However, the cooling intermediate composite body 3000 differs from the cooling intermediate composite body 402 in the following ways. The inside is formed to include an internal opening similar to the second opening formed on the bonding layer 41. The outer block 53A is fixed to the base block 21B with two screws at each of the four corners. No thermal conductive sheet is used. In this example, the back surface of the outer block 53A does not need to be thermally connected to the surface of the base block 21B. The outer block 53A has the watertightness maintenance function, but does not need to have the heat transfer function. On the other hand, the surface of the base block 21B partially comes into direct contact with the coolant outside the bag 11 via the second opening in the bonding layer 41, the first opening in the bag 11, and the opening in the outer block 53A. The base block 21B has the functions of removing heat from and protecting the heat-generating element, as well as watertightness maintenance and external heat dissipation. This may be one of the examples, including the heat sink device that is structured most simply and is composed of a combination of the minimum number of blocks.

The example illustrated in Fig. 27(B) is a modified version of the example illustrated in Fig. 27(A). A cooling intermediate composite body 3001 according to the example in Fig. 25 differs from the cooling intermediate composite body 3000 illustrated in Fig. 25 in the following ways. The fin area 212 exists on the surface side of the base block 21B. The fin area 212 includes many plate-shaped fins rising from the base 211. The fins provided for the fin area 212 are exposed from the bag 11 through the second opening in the bonding layer 41, the first opening in the bag 11, and the opening in the outer block 53A. Many fins on the fin area 212 can increase the heat dissipation area and enhance the external heat dissipation function. In this modified example, the flat surface (surface) of the base block 21B is placed inside the bag 11. The back surface of the outer block 25, which is placed outside, and the surface of the base block 21B function to maintain watertightness on both sides of the region around the first opening. The base block "being placed inside the non-conductive bag" should be understood to include a configuration in which the main part (base) of the base block is placed inside the bag and part of the base block (the plurality of the fins in this example) is placed outside the bag, as explained in this modified example. The base block "being placed outside the non-conductive bag" should be understood to include also a configuration in which the main part of the outer block is placed outside the bag, and part of the outer block (such as the elevated portion) is placed inside the bag.

While the preferred examples and modified examples have been described by referencing the drawings, the details of the components may be further modified. For example, as already described in relation to the bonding layer, watertightness may be further enhanced by additionally installing double-sided adhesive tape or watertight packing between the exterior of the non-conductive bag 11 and the back surface of the outer block 23A, or between the exterior of the non-conductive bag 11 and the back surface of the lower outer block 43B, to surround the opening of the bag 11, in the examples of the cooling intermediate composite bodies 101, 102, 103, 600, 601, 602, 800, 801, 802, 900, 901, 902, 1000, and 2000. As another example of enhancing watertightness, mutually engaging fine concave-convex surfaces may be formed on the back surface of the outer block 23A and the surface of the base block 21B/23B so that the mutually engaging concave-convex surfaces can prevent exposure to the coolant.

Referring again to Fig. 13, examples of the operation of the cooling system 1 will be described in more detail. Two or more cooling intermediate composite bodies 100 may be immersed in the coolant 4 contained in the cooling tank 3. A top plate 3A may be provided for the cooling tank 3 to reduce evaporation of the coolant 4. The cooling intermediate composite body 100 of the cooling system 1 may replace the power cable with a wireless power supply unit (not shown), which is included in the non-conductive bag 11, so that the electronic apparatus 10 is supplied with power. The network communication cable may be replaced with a wireless communication unit (not shown) to be included in the non-conductive bag 11 so that the electronic apparatus 10 can wirelessly communicate with the outside. In this case, there is no need for the penetration portion to pass cables, and the sealing material provided for the penetration portion. It is possible to eliminate the need for ensuring and maintaining the hermeticity of the penetration portion.

The cooling intermediate composite body 100 of the cooling system 1 may allow the non-conductive bag 11 to include a monitor unit 120 that monitors the vacuum level or conductivity in the non-conductive bag 11. Conductivity monitoring in the bag is beneficial from the viewpoint of preventing the electronic apparatus from malfunctioning for the purpose of confirming the presence or absence of water or water vapor in the bag, which could damage printed circuit boards or electronic components due to electrical shorts. Furthermore, the cooling system 1 may include a controller 160 that provides control to activate the external vacuum pump 7 and vacuumize the non-conductive bag 11 via the air tube 9 connected to the check valve 19 when an output of the monitor unit 120 indicates a vacuum level below a predetermined threshold. Advantageously, an operator can visually check output values from the monitor unit 120 or operating states of the controller 160 on a computer (PC) 180 communicatively connected to the controller 160. It is possible to perform the vacuumization autonomously as needed, while monitoring the vacuum level, and maintain the near-vacuum sealed structure of the cooling intermediate composite body 100 for an extended period of time. Additionally or alternatively, the cooling system 1 may include a shutdown unit 140 that stops operation of the electronic apparatus 10 and cuts electricity when an output of the monitor unit 120 indicates a vacuum level below a predetermined threshold or a conductivity higher than or equal to a predetermined threshold. If the vacuum or watertightness of the cooling intermediate composite body 100 is damaged, the surrounding coolant may seep into the cooling intermediate composite body 100 to cause an electrical short and potentially irreversible damage to the entire electronic apparatus 10. The shutdown unit 140 can prevent such a problem by instantly stopping the operation and power supply to the electronic apparatus 10.

The components of the cooling system according to the above-described embodiments can be modified variously. For example, the non-conductive bag may include a heat-sealing mechanism instead of the zipper mechanism. The heat-sealing mechanism may be configured so that an unheat-sealed state allows the electronic apparatus to be placed inside the non-conductive bag, and after heat sealing, a heat-sealed state permits the necessary vacuumization and maintains the watertightness of the non-conductive bag. When the cooling system is in operation, the heat-sealing mechanism may remain open partially. The cooling intermediate composite body may be immersed in the coolant so that the heat-sealing mechanism is positioned above the coolant liquid level. The bag is then pressed by the surrounding coolant pressure to discharge the air from the bag to the outside. Concurrently, the interior of the non-conductive bag may relatively closely contact both sides of the printed circuit board and the surfaces of various electronic components mounted on the printed circuit board. If two or more heat-generating elements are mounted on the printed circuit board of an electronic apparatus, it may be advantageous to appropriately determine the size and/or the number of heat sink devices, the selection of materials for each block, the combination of blocks made of different materials, the size and/or the number of heterogeneous-material bonding films, double-sided adhesive tapes, or watertight packings forming the bonding layer, the size and/or the number of the second openings (windows) formed on these, and the position, size, and/or the number of the first openings (windows) formed on the non-conductive bag in consideration of the positions of the two or more heat-generating elements mounted on the printed circuit board, the size of the heat-generating elements, and the estimated maximum heat value.

The present invention can be widely applied to cooling systems and methods that efficiently cool the electronic apparatus by immersing it in a conductive coolant, such as ordinary water, tap water, or seawater.

### REFERENCE SIGNS LIST

1 cooling system
3 cooling tank
3A top plate
4 coolant (water)
5 piping
7 vacuum pump
9 air tube
10 electronic apparatus
100, 101, 102, 300, 301, 400, 401, 402, 500, 501, 502, 600, 601, 602, 700, 701, 702, 800, 801, 802, 900, 901, 1000, 2000 cooling intermediate composite body
120 vacuum level / conductivity monitor unit
140 shutdown unit
160 controller
180 computer (PC)
11 non-conductive bag
11A exterior
11B interior
15 first opening
17 sealing material
19 check valve
20 zipper mechanism
21 heat sink device
21A, 23A, 43A, 43B, 53A outer block
21B, 23B, 24B base block
211 base
212 fin area
212B flat surface (first back surface)
213 elevated portion
213B flat surface (second back surface)
215 threaded hole (through hole)
21B base block
221 plate-like member
221A surface
221B back surface
225, 227 threaded hole
25, 27 screw
28 support screw
29 pushpin
31 printed circuit board (PCB)
32 spacer
33 heat-generating element (CPU)
34 thermal conductive grease
35 electronic component
36 network communication cable
37 power cable
38 stiffener
41 bonding layer
43 second opening
51 thermal conductive sheet

## Claims

1. A cooling system for cooling an electronic apparatus by immersing it in a coolant, comprising:
a cooling intermediate composite body,
wherein the cooling intermediate composite body includes a non-conductive bag that encloses an electronic apparatus including a printed circuit board and at least one heat-generating element mounted on the printed circuit board; a thermal conductive base block placed inside the non-conductive bag; and a heat sink device that is placed outside the non-conductive bag and includes a thermal conductive outer block fixed to the base block;
wherein a first opening is formed on the non-conductive bag;
wherein, when the outer block is fixed to the base block, the outer block and the base block are thermally connected through the first opening of the non-conductive bag;
wherein the back surface of the outer block and a surface of the base block maintain watertightness on both sides of a region around the first opening of the non-conductive bag; and
wherein the surface of the base block back provides a connecting surface that is thermally connected to one side of at least the one heat-generating element.

2. The cooling system according to claim 1,
wherein an elevated portion is formed on the back surface of the outer block or the surface of the base block, and the elevated portion contacts the surface of the base block or the back surface of the outer block through the first opening of the non-conductive bag.

3. The cooling system according to claim 2,
wherein the first opening formed on the non-conductive bag has an opening area larger than an area of the elevated portion.

4. The cooling system according to claim 1,
wherein a thermal conductive sheet or thermal conductive grease is provided to fill the first opening of the non-conductive bag, and the back surface of the outer block contacts the surface of the base block via the thermal conductive sheet or the thermal conductive grease.

5. The cooling system according to claim 1,
wherein the outer block includes a thermal conductive lower outer block and a thermal conductive upper outer block that is thermally connected to and fixed to the surface of the lower outer block; and
wherein, when the lower outer block is fixed to the base block, the back surface of the lower outer block and the surface of the base block maintain watertightness on both sides of a region around the first opening of the non-conductive bag.

6. The cooling system according to claim 1,
wherein the base block includes a thermal conductive lower base block and a thermal conductive upper base block that is thermally connected to and fixed to the surface of the lower base block; and
wherein, when the outer block is fixed to the upper base block, the back surface of the outer block and the surface of the upper base block maintain watertightness on both sides of a region around the first opening of the non-conductive bag.

7. The cooling system according to claim 1,
wherein the outer block includes a thermal conductive lower outer block and a thermal conductive upper outer block that is thermally connected to and fixed to the surface of the lower outer block;
wherein the base block includes a thermal conductive lower base block and a thermal conductive upper base block that is thermally connected to and fixed to the surface of the lower base block; and
wherein, when the lower outer block is fixed to the upper base block, the back surface of the lower outer block and the surface of the upper base block maintain watertightness on both sides of a region around the first opening of the non-conductive bag.

8. The cooling system according to claim 1, 5, 6, or 7,
wherein a material used for the outer block, the upper outer block, or the lower outer block differs from a material used for the base block, the upper base block, or the lower base block.

9. The cooling system according to claim 1, 5, 6, or 7,
wherein a plurality of convex surfaces of different heights is formed on the back surface of the base block or the back surface of the lower base block; and
wherein a plurality of the convex surfaces is thermally connected to a plurality of surfaces of a plurality of heat-generating elements of different heights.

10. The cooling system according to claim 1, 5, 6, or 7,
wherein the base block or the lower base block includes a PCB fixing mechanism; and
wherein the printed circuit board of the electronic apparatus is fixed to the PCB fixing mechanism of the base block or the lower base block.

11. The cooling system according to claim 10,
wherein the PCB fixing mechanism of the base block or the lower base block provides two or more threaded holes that are mutually separately formed on the back surface of the base block or the lower base block.

12. The cooling system according to claim 1,
wherein the cooling intermediate composite body further includes a bonding layer that makes a watertight connection between the back surface of the outer block and an exterior of the non-conductive bag, or between the surface of the base block and an interior of the non-conductive bag;
wherein the bonding layer is formed of a heterogeneous-material bonding film, double-sided adhesive tape, or watertight packing;
wherein a second opening corresponding to the first opening of the non-conductive bag is formed on the heterogeneous-material bonding film, double-sided adhesive tape, or watertight packing; and
wherein the outer block and the base block are thermally connected through the first opening in the non-conductive bag and the second opening in the bonding layer.

13. The cooling system according to claim 12,
wherein an elevated portion is formed on the back surface of the outer block or the surface of the base block; and
wherein the elevated portion contacts the surface of the base block or the back surface of the outer block through the first opening in the non-conductive bag and the second opening in the bonding layer.

14. The cooling system according to claim 13,
wherein the first opening in the non-conductive bag and the second opening in the bonding layer have an open area larger than an area of the elevated portion.

15. The cooling system according to claim 12,
wherein a thermal conductive sheet or thermal conductive grease is provided to fill the first opening of the non-conductive bag and the second opening of the bonding layer; and
wherein the back surface of the outer block contacts the surface of the base block via the thermal conductive sheet or the thermal conductive grease.

16. The cooling system according to claim 12,
wherein the outer block includes a thermal conductive lower outer block and a thermal conductive upper outer block that is thermally connected to and fixed to the surface of the lower outer block; and
wherein, when the lower outer block is fixed to the base block, the back surface of the lower outer block and the surface of the base block maintain watertightness in a region around the first opening of the non-conductive bag and a region around the second opening of the bonding layer.

17. The cooling system according to claim 12,
wherein the base block includes a thermal conductive lower base block and a thermal conductive upper base block that is thermally connected to and fixed to the surface of the lower base block; and
wherein, when the outer block is fixed to the upper base block, the back surface of the outer block and the surface of the upper base block maintain watertightness in a region around the first opening of the non-conductive bag and a region around the second opening of the bonding layer.

18. The cooling system according to claim 12,
wherein the outer block includes a thermal conductive lower outer block and a thermal conductive upper outer block that is thermally connected to and fixed to the surface of the lower outer block;
wherein the base block includes a thermal conductive lower base block and a thermal conductive upper base block that is thermally connected to and fixed to the surface of the lower base block; and
wherein, when the lower outer block is fixed to the upper base block, the back surface of the lower outer block and the surface of the upper base block maintain watertightness in a region around the first opening of the non-conductive bag and a region around the second opening of the bonding layer.

19. The cooling system according to claim 12, 16, 17, or 18,
wherein a plurality of convex surfaces of different heights is formed on the back surface of the base block or the back surface of the lower base block; and
wherein a plurality of the convex surfaces is thermally connected to a plurality of surfaces of a plurality of heat-generating elements of different heights.

20. The cooling system according to claim 12, 16, 17, or 18,
wherein the base block or the lower base block includes a PCB fixing mechanism; and
wherein the printed circuit board of the electronic apparatus is fixed to the PCB fixing mechanism of the base block or the lower base block.

21. The cooling system according to claim 20,
wherein the PCB fixing mechanism of the base block or the lower base block provides two or more threaded holes that are mutually separately formed on the back surface of the base block or the lower base block.

22. The cooling system according to claim 1,
wherein the heat sink device includes a plurality of radiating fins placed outside the non-conductive bag.

23. The cooling system according to claim 1,
wherein, when the non-conductive bag is immersed in a coolant, the cooling intermediate composite body is configured so that a hydraulic pressure causes the interior of the non-conductive bag to contact both sides of the printed circuit board and surfaces of various electronic components mounted on the printed circuit board.

24. The cooling system according to claim 1,
wherein, when the interior of the non-conductive bag is vacuumized as necessary, the cooling intermediate composite body is configured so that the interior of the non-conductive bag comes into close contact with both sides of the printed circuit board and surfaces of various electronic components mounted on the printed circuit board.

25. The cooling system according to claim 24,
wherein the non-conductive bag is configured to include a check valve that can provide a vacuumization path and maintain hermeticity.

26. The cooling system according to claim 24,
wherein the non-conductive bag includes a zipper mechanism; and
wherein the zipper mechanism is configured so that a zipper opened state allows the electronic apparatus to be placed inside the non-conductive bag and a zipper opened state maintains the hermeticity of the non-conductive bag.

27. The cooling system according to claim 24,
wherein the non-conductive bag includes a heat-sealing mechanism; and
wherein the heat-sealing mechanism is configured so that an unheat-sealed state allows the electronic apparatus to be placed inside the non-conductive bag and, after heat sealing, a heat-sealed state allows a water penetration part to be watertight after immersion in the water and maintains watertightness.

28. The cooling system according to claim 24,
wherein the non-conductive bag includes a heat-sealing mechanism; and
wherein the heat-sealing mechanism is configured so that an unheat-sealed state allows the electronic apparatus to be placed inside the non-conductive bag and, after heat sealing, a heat-sealed state permits vacuumization as needed and maintains hermeticity of the non-conductive bag.

29. The cooling system according to claim 22 or 24,
wherein the non-conductive bag is configured to include a through hole formed therein for passing a power cable, a network communication cable, or a control cable connected to an electronic apparatus; and
wherein a sealing material provided for the through hole is configured to maintain the watertightness or hermeticity of the non-conductive bag.

30. The cooling system according to claim 23 or 24,
wherein the cooling intermediate composite body allows the non-conductive bag to further include a wireless power supply unit for supplying power to the electronic apparatus and a wireless communication unit for enabling wireless communication between the electronic apparatus and the outside.

31. The cooling system according to claim 23 or 24,
wherein the cooling intermediate composite body allows the non-conductive bag to further include a monitor unit for monitoring the degree of vacuum or conductivity in the non-conductive bag.

32. The cooling system according to claim 31, further comprising:
an exhaust controller that provides control to start a vacuum pump provided outside the cooling intermediate composite body and vacuumize the non-conductive bag when an output of the monitor unit indicates a vacuum level below a predetermined threshold.

33. The cooling system according to claim 31, further comprising:
a shutdown unit that stops operation of the electronic apparatus and cuts electricity when an output of the monitor unit indicates a vacuum level below a predetermined threshold or a conductivity higher than or equal to a predetermined threshold.

34. A cooling system for cooling an electronic apparatus by immersing it in a coolant, comprising:
a cooling intermediate composite body,
wherein the cooling intermediate composite body includes a non-conductive bag that encloses an electronic apparatus including a printed circuit board and at least one heat-generating element mounted on the printed circuit board; a thermal conductive base block placed inside the non-conductive bag; and a heat sink device that is placed outside the non-conductive bag and includes a thermal conductive outer block fixed to the base block;
wherein a first opening is formed on the non-conductive bag;
wherein, when the outer block is fixed to the base block, the back surface of the outer block and a surface of the base block maintain watertightness on both sides of a region around the first opening of the non-conductive bag; and
wherein the back surface of the base block provides a connecting surface that is thermally connected to one side of at least the one heat-generating element.

35. A cooling method for electronic apparatuses, comprising the steps of:
preparing a heat sink device that includes a thermal conductive base block and a thermal conductive outer block;
preparing a non-conductive bag that encloses an electronic apparatus including a printed circuit board and at least one heat-generating element mounted on the printed circuit board, and includes a first opening formed for the heat sink device;
configuring a cooling intermediate composite body including a step of fixing the outer block, placed outside the non-conductive bag, to a thermal conductive base block placed inside the non-conductive bag, **characterized by** that, when the outer block is fixed to the base block, the outer block is thermally connected to the base block through the opening formed on the non-conductive bag, and the back surface of the outer block and the surface of the base block maintain watertightness on both sides of a region around the first opening of the non-conductive bag;
placing the electronic apparatus in the cooling intermediate composite body and fixing the base block to the printed circuit board so that one surface of at least one heat-generating element makes surface contact with and thermally connects with the back surface of the base block;
making the non-conductive bag watertight at least partially; and
immersing, in a coolant, a watertight part of the at least partially watertight cooling intermediate composite body.

36. A cooling method for electronic apparatuses, comprising the steps of:
preparing a heat sink device that includes a thermal conductive base block and a thermal conductive outer block;
preparing a non-conductive bag that encloses an electronic apparatus including a printed circuit board and at least one heat-generating element mounted on the printed circuit board, and includes a first opening formed for the heat sink device;
fixing the base block to the printed circuit board so that one surface of at least the one heat-generating element makes surface contact with and thermally connects with the back surface of the base block of the heat sink device;
configuring a cooling intermediate composite body including a step of placing the electronic apparatus equipped with the base block in the non-conductive bag and a step of fixing the outer block, placed outside the non-conductive bag, to the base block, **characterized by** that, when the outer block is fixed to the base block, the outer block is thermally connected to the base block through the first opening formed on the non-conductive bag, and the back surface of the outer block and the surface of the base block maintain watertightness on both sides of a region around the opening of the non-conductive bag;
making the non-conductive bag watertight at least partially; and
immersing, in a coolant, a watertight part of the at least partially watertight cooling intermediate composite body.

37. A cooling method for electronic apparatuses, comprising the steps of:
preparing a heat sink device that includes a thermal conductive base block and a thermal conductive outer block;
preparing a non-conductive bag that encloses an electronic apparatus including a printed circuit board and at least one heat-generating element mounted on the printed circuit board, and includes a first opening formed for the heat sink device;
configuring a cooling intermediate composite body including a step of fixing the outer block, placed outside the non-conductive bag, to a thermal conductive base block placed inside the non-conductive bag, **characterized by** that, when the outer block is fixed to the base block, the back surface of the outer block and the surface of the base block maintain watertightness on both sides of a region around the first opening of the non-conductive bag;
placing the electronic apparatus in the cooling intermediate composite body and fixing the base block to the printed circuit board so that one surface of at least the one heat-generating element makes surface contact with and thermally connects with the back surface of the base block;
making the non-conductive bag watertight at least partially; and
immersing, in a coolant, a watertight part of the at least partially watertight cooling intermediate composite body.

38. A cooling method for electronic apparatuses, comprising the steps of:
preparing a heat sink device that includes a thermal conductive base block and a thermal conductive outer block;
preparing a non-conductive bag that encloses an electronic apparatus including a printed circuit board and at least one heat-generating element mounted on the printed circuit board and includes a first opening formed for the heat sink device;
fixing the base block to the printed circuit board so that one surface of at least the one heat-generating element makes surface contact with and thermally connects with the back surface of the base block of the heat sink device;
configuring a cooling intermediate composite body including a step of placing the electronic apparatus equipped with the base block in the non-conductive bag and a step of fixing the outer block, placed outside the non-conductive bag, to the base block, **characterized by** that, when the outer block is fixed to the base block, the back surface of the outer block and the surface of the base block maintain watertightness on both sides of a region around the opening of the non-conductive bag;
making the non-conductive bag watertight at least partially; and
immersing, in a coolant, a watertight part of the at least partially watertight cooling intermediate composite body.

39. The method according to any one of claims 35 through 38,
wherein the step of fixing the outer block to the base block includes a step of bonding between the back surface of the outer block and an exterior of the non-conductive bag, or between the surface of the base block and an interior of the non-conductive bag, using a heterogeneous-material bonding film, double-sided adhesive tape, or watertight packing.

40. The method according to any one of claims 35 through 38,
wherein the step of making the non-conductive bag watertight at least partially includes a step of vacuumizing the non-conductive bag.

41. The method according to any one of claims 35 through 38,
wherein, when the step of immersing the cooling intermediate composite body in a coolant immerses the non-conductive bag at least partially in the coolant, the step of making the non-conductive bag watertight at least partially is achieved by allowing a hydraulic pressure of the coolant to contact a partial interior of the non-conductive bag with both sides of the printed circuit board and surfaces of various electronic components mounted on the printed circuit board.
